(19) Europäisches Patentamt
European Patent Office
Office européen des brevets

(11) Veröffentlichungsnummer : **0 272 215 B1**

# (12) EUROPÄISCHE PATENTSCHRIFT

(45) Veröffentlichungstag der Patentschrift : **08.03.95 Patentblatt 95/10**

(51) Int. Cl.[6] : **G03F 7/20,** G03F 7/029

(21) Anmeldenummer : **87810742.4**

(22) Anmeldetag : **11.12.87**

## (54) Verfahren zur Bilderzeugung.

(30) Priorität : **17.12.86 GB 8630129**
**22.04.87 GB 8709520**

(43) Veröffentlichungstag der Anmeldung : **22.06.88 Patentblatt 88/25**

(45) Bekanntmachung des Hinweises auf die Patenterteilung : **08.03.95 Patentblatt 95/10**

(84) Benannte Vertragsstaaten : **BE CH DE ES FR GB IT LI NL SE**

(56) Entgegenhaltungen :
**EP-A- 0 094 915**
**EP-A- 0 151 372**
**EP-A- 0 177 453**
**GB-A- 2 127 324**
**US-A- 4 291 118**

(73) Patentinhaber : **CIBA-GEIGY AG**
**Klybeckstrasse 141**
**CH-4002 Basel (CH)**

(72) Erfinder : **Banks, Christopher Paul**
**105 Ross Close**
**Saffron Walden Essex CB11 4DU (GB)**
Erfinder : **Demmer, Christopher George, Dr.**
**8 Southfield**
**Ickleton**
**Saffron Walden Essex CB10 1TE (GB)**
Erfinder : **Irving, Edward, Dr.**
**41 Swaffham Road**
**Burwell Cambridge CB5 0A (GB)**

(74) Vertreter : **Sharman, Thomas et al**
**CIBA-GEIGY PLC.**
**Patent Department,**
**Central Research,**
**Hulley Road**
**Macclesfield, Cheshire SK10 2NX (GB)**

EP 0 272 215 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zur Bilderzeugung, das für die Herstellung von Druckplatten und gedruckten Schaltungen eingesetzt werden kann.

In konventionellen Verfahren zur Herstellung von Positivbildern wird ein Substrat mit einer Lösung eines positiven Photoresists in einem leicht flüchtigen organischen Lösungsmittel beschichtet und das Lösungsmittel wird verdampft, um eine feste Schicht des Photoresists auf dem Substrat zu erhalten. Das feste Photoresist, wie z.B. ein Phenol-Novolakharz, das einen Chinondiazidrest enthält, oder ein Gemisch eines filmbildenden Harzes und eines Chinondiazids, wird dann in einem vorbestimmten Muster, üblicherweise durch ein bildtragendes Dia, aktinischer Strahlung ausgesetzt, wobei die bestrahlten Teile des Photoresists im für die Entwicklung verwendeten Lösungsmittel löslicher werden, während die nicht bestrahlten Teile unverändert bleiben. Die bestrahlten Teile werden mit einem Entwickler, üblicherweise einer wässrigen Alkalilösung, entfernt, wodurch ein Positivbild erhalten wird.

Es besteht ein Bedarf für ein Verfahren, in dem eine feste, im wesentlichen nicht klebrige Schicht eines Positivresists direkt im vorbestimmten Muster bestrahlt werden kann, ohne dass vorher ein organisches Lösungsmittel entfernt werden müss. Dadurch könnte die Verwendung von Lösungsmitteln, welche oft wegen ihrer Toxizität und Entflammbarkeit bedenklich sind, und deren Rückgewinnung Kosten verursacht, vermieden werden. Ein solches Verfahren würde auch die kontinuierliche Herstellung von mit Photoresists beschichteten Unterlagen, wie z.B. von kupferbeschichteten Laminaten, ermöglichen, die dann direkt bildmässig bestrahlt werden könnten.

In der EP-A 155 231 wurde vorgeschlagen, ein Positivbild durch bildmässige Bestrahlung einer durch Elektrobeschichtung gebildeten Photoresistschicht zu erzeugen. Obwohl bei diesem Verfahren nur geringe Mengen organischer Lösungsmittel eingesetzt werden müssen, werden dabei Stoffe mit salzbildenden Gruppen verwendet, so dass das Verfahren nur begrenzt anwendbar ist. Es besteht daher der Bedarf für ein im breiteren Rahmen anwendbares Verfahren, bei dem keine organischen Lösungsmittel verwendet und entfernt werden müssen.

Gegenstand vorliegender Erfindung ist ein Verfahren zur Bilderzeugung, worin

(i) ein Substrat mit einer flüssigen Zusammensetzung enthaltend

(A) einen kationisch oder durch Einwirkung freier Radikale polymerisierbaren Rest,

(B) einen strahlungsaktivierbaren Polymerisationsinitiator für (A) und

(C) einen strahlungssolubilisierbaren Rest beschichtet wird,

(ii) die Zusammensetzung mit Strahlen einer Wellenlänge belichtet wird, bei der (B) aktiviert wird, aber (C) im wesentlichen nicht aktiviert wird, sie anschliessend gegebenenfalls erhitzt wird, wobei (A) polymerisiert und die flüssige Zusammensetzung sich verfestigt,

(iii) die verfestigte Schicht in einem vorbestimmten Muster mit einer Strahlung verschiedener Wellenlänge als die in Stufe (ii) verwendete belichtet, wobei der Rest (C) aktiviert wird, so dass die verfestigte Schicht in den belichteten Bereichen der Oberfläche in einem Entwickler löslicher wird als in den unbelichteten Bereichen und

(iv) die belichteten Bereiche der Schicht durch Einwirkung eines Entwicklers entfernt werden.

Der Satz "in einem vorbestimmten Muster ...... belichtet" umfasst sowohl die Bestrahlung durch ein bildtragendes Dia, als auch Bestrahlung mit einem Energiestrahl wie z.B. einem vom Computer dirigierten Laserstrahl, um ein Bild zu erzeugen.

Das im vorliegenden Verfahren verwendete flüssige Stoffgemisch kann einen strahlungsaktivierbaren Initiator (B) enthalten und entweder (1) ein Gemisch mindestens einer Verbindung mit einem polymerisierbaren Rest (A) und mindestens einer Verbindung mit einem durch Strahlung solubilisierbaren Rest (C), der bei Strahlung verschiedener Wellenlänge als (B) aktiviert wird, oder (2) mindestens eine doppelfunktionelle Verbindung, welche im gleichen Molekül sowohl einen polymerisierbaren Rest (A) als auch einen durch Strahlung solubilisierbaren Rest (C), der bei Strahlung verschiedener Wellenläge als (B) aktiviert wird, enthält, oder (3) mindestens eine der oben erwähnten doppelfunktionellen Verbindungen zusammen mit mindestens einer Verbindung mit einem polymerisierbaren Rest (A) und/oder mindestens eine Verbindung mit einem durch Strahlung solubilisierbaren Rest (C).

Der Rest (C) kann durch Strahlung einer kürzeren Wellenlänge als der Rest (B) aktiviert werden. In dieser Ausführungsform kann die Bestrahlung in den Stufen (ii) und (iii) mit UV-Strahlen erfolgen, wobei in Stufe (iii) Strahlung kürzerer Wellenlänge verwendet wird, oder vorzugsweise, kann die erste Bestrahlung mit sichtbarem Licht und die zweite mit UV-Strahlung erfolgen. In einer anderen Ausführungsform kann (C) mit Strahlen längerer Wellenlänge als (B) aktiviert werden.

Der Polymerisationsinitiator (B) muss Strahlung längerer oder kürzerer Wellenlänge als der photosolubilisierbare Rest (C) absorbieren. Falls (B) bei längerer Wellenlänge absorbiert, absorbiert der Rest

(C) vorzugsweise nicht bei einer Wellenlänge von über 500 nm.

Reste, d.h. Gruppen oder Kombinationen von Gruppen, die durch freie Radikale polymerisiert werden können und als Komponente (A) des flüssigen Stoffgemisches verwendet werden können, sind wohlbekannt und können z.B. ethylenisch ungesättigte Gruppen oder Gemische dieser Gruppen und Thiogruppen sein.

Geeignete Verbindungen mit ethylenisch ungesättigten Gruppen sind z.B. vinylsubstituierte Aromate, wie Styrol, substituierte Styrole, z.B. α-Methylstyrol, 4-Methylstyrol und 4-Bromstyrol, Vinylester, wie Vinylacetat, Allylverbindungen, wie Diallylmaleat und Dimethallylfumarat und Vinyl-Heterocyclen, wie 2-, 3- oder 4-Vinylpyridin und 2- oder 3-Vinylpyrrolidin.

Bevorzugte ethylenisch ungesättigte Verbindungen sind Ester ethylenisch ungesättigter Monocarbonsäuren, insbesondere solche mit einer Gruppe der Formel I

$$CH_2=C(R^1)COO- \quad (I),$$

worin $R^1$ Wasserstoff, Chlor oder Brom oder eine Alkylgruppe mit 1 bis 4 Kohlenstoffatomen, insbesondere ein Wasserstoffatom oder eine Methylgruppe, ist. Geeignete derartige Ester sind z.B. Acrylate und 2-substituierte Acrylate einwertiger Alkohole, z.B. von 2-Methoxyethanol, 2-Cyanoethanol, Furfurylalkohol, Glycidol und Cyclohexanol, sowie Teilester oder Ester mehrwertiger Alkohole, z.B. von Butandiol, Pentaerythrit, Dipentaerythrit, Tri- und Tetraethylenglykolen, Trimethylolpropan und Glycerin. Geeignet sind auch Ester, die durch Umsetzung eines Alkylenoxids, insbesondere Ethylenoxids oder Propylenoxids, mit einer Acrylsäure erhalten werden, wie z.B. 2-Hydroxyethyl- und 2-Hydroxypropylacrylate und -methacrylate. Es können auch Ester verwendet werden, welche durch Umsetzung einer eine oder mehrere Glycidylgruppen enthaltenden Verbindung, insbesondere eines Mono- oder Polyglycidylethers eines ein- oder mehrwertigen Alkohols oder Phenols, oder eines N-Glycidylhydantoins mit Acryl- oder Methacrylsäure hergestellt werden können. Weitere geeignete Verbindungen sind Ester, hergestellt durch Umsetzung eines Diepoxids mit einem Addukt eines Hydroxyalkylacrylats oder -methacrylats mit einem gesättigten oder ungesättigten Dicarbonsäureanhydrid, wie z.B. mit Bernstein-, Malein-, oder Phthalsäureanhydrid.

Typische derartige Verbindungen sind z.B. 1,4-Bis(2-hydroxy-3-acryloyloxypropoxy)butan, ein Poly(2-hydroxy-3-acryloyloxypropyl)ether eines Bisphenols oder eines Phenol-Formaldehyd-Novolaks, 2,2-Bis[4-(2-hydroxy-3-(2-acryloyloxyethoxy)succinyloxypropoxy)phenyl]propan, Neopentyldiacrylat, Trimethylolpropantrisacrylat, Pentaerythrittetracrylat, Bis(2-hydroxy-3-acryloyloxypropyl)adipat und die entsprechenden Methacrylate.

Besonders bevorzugte ethylenisch ungesättigte Verbindungen sind solche mit einer ethylenisch ungesättigten Gruppe, insbesondere Monoacrylate und Monomethacrylate, wie z.B. Acrylsäure, 1-(2-Hydroxy-3-acryloyloxypropoxy)-butan, -octan und -decan, 2-Hydroxy-3-acrylyloxypropylpropionat, 3-Phenoxy-2-hydroxpropylacrylat, 2-Hydroxyethylacrylat, 2-Hydroxypropylacrylat und die entsprechenden Methacrylate.

Polyfunktionelle Acrylate und Methacrylate werden im allgemeinen zusammen mit monofunktionellen Acrylaten und Methacrylaten verwendet.

Polyene, welche in Gemischen mit Polythiolen als Komponente (A) verwendet werden können, umfassen Verbindungen mit mindestens zwei Gruppen der Formel II oder III

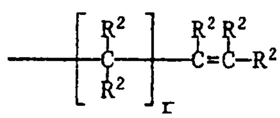

(II)

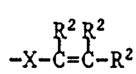

(III) ,

worin die Gruppen $R^2$, welche gleich oder verschieden sein können, Wasserstoff-, Fluor- und Chloratome sowie Furyl, Thienyl, Pyridyl, Phenyl, substituiertes Phenyl, Benzyl und substituiertes Benzyl, Alkyl, substituiertes Alkyl, Alkoxy und substituiertes Alkoxy mit 1 bis 9 Kohlenstoffatomen und Cycloalkyl und substituiertes Cycloalkyl mit 3 bis 8 Kohlenstoffatomen sind, wobei die Substituenten unter Chlor- oder Fluoratomen, Acetoxy-, Nitro-, Acetamido-, Phenyl-, Benzyl-, Alkyl-, Alkoxy- und Cycloalkylgruppen ausgewählt werden können, r eine ganze Zahl von 1 bis 9 ist und X eine Gruppe $-NR^2-$, -O-, oder -S- darstellt.

Die Polyene haben im allgemeinen ein Molekulargewicht von 50 bis 5000 und enthalten zwei oder mehrere ethylenische Bindungen, welche durch freie Radikale polymerisierbar sind. Bevorzugte Polyene sind z.B. das Umsetzungsprodukt von 1 Mol Tolylendiisocyanat mit 2 Mol eines Dialkenylethers von Trimethylolpropan, das Umsetzungsprodukt von 1 Mol eines polymeren Diisocyanats mit 2 Mol Allylalkohol, das Umsetzungsprodukt von 1 Mol Polyethylenglykol mit 2 Mol Tolylen-2,4-diisocyanat und 2 Mol Allylalkohol, Polyisopren, Polybutadien

und andere ungesättigte Polymere, welche die Doppelbindungen primär in der Hauptkette des Moleküls haben, Verbindungen mit reaktiven ungesättigten Kohlenstoff-Kohlenstoff-Bindungen, die mit benachbarten ungesättigten Gruppen konjugiert sind, wie z.B. Polyethylenetherglykoldiacrylat mit einem Molekulargewicht von etwa 750, Polytetramethylenetherglykoldimethacrylat mit einem Molekulargeiwcht von etwa 1175 und das Triacrylat des Reaktionsproduktes von Trimethylolpropan mit 20 Mol Ethylenoxid, sowie Reaktionsprodukte von Polyepoxiden mit Aminen, Alkoholen, Thioalkoholen, oder aliphatisch ungesättigten Säuren, wie z.B. das Reaktionsprodukt von Bisphenol A Diglycidylether mit Allylamin oder Diallylamin. Besonders bevorzugte Polyene sind Phenole, insbesondere Bisphenole, welche durch zwei oder mehrere Allyl- oder Methylgruppen substituiert sind.

Polythiole, welche mit diesen Polyenen im Gemisch auch als Komponente (A) verwendet werden können, haben die allgemeine Formel IV

$$R^3(SH)_t \qquad (IV),$$

worin $R^3$ eine mehrwertige organische Gruppe darstellt, die keine reaktiven CC Doppelbindungen hat, und t mindestens 2 ist.

Vorzugsweise ist die organische Gruppe $R^3$ eine Alkylengruppe mit 2 bis 10 Kohlenstoffatomen, eine Arylengruppe mit 6 bis 10 Kohlenstoffatomen, eine Alkarylengruppe mit 7 bis 16 Kohlenstoffatomen, eine Cycloalkylengruppe mit 5 bis 10 Kohlenstoffatomen oder eine Cycloalkylalkylengruppe mit 6 bis 16 Kohlenstoffatomen, wobei jede dieser Gruppen substituiert sein kann und Sauerstoffatome oder Estergruppen in den Alkylenketten enthalten kann. Spezifische Beispiele bevorzugter Polythiole sind z.B. Ethylenglykol-bis(thioglykolat), Ethylenglykol-bis(β-mercaptopropionat), Trimethylolpropan-tris(thioglykolat), Trimethylolpropantris-(β-mercaptopropionat), Pentaerythrit-tetrakis(thioglykolat), Pentaerythrit-tetrakis(β-mercaptopropionat) und Thioglykolate, β-Mercaptopropionate und 3-Mercapto-2-hydroxypropylether von Polyalkylenglykolen und -triolen, wie z.B. Polypropylenetherglykol-bis(β-mercaptopropionat) und 3-Mercapto-2-hydroxypropylether eines von Glycerin abgeleiteten Polyoxypropylentriols.

Das Molverhältnis der En:Thiol-Gruppen muss so gewählt werden, dass nach der Bestrahlung ein festes Produkt entsteht, wobei Molverhältnisse von 1:0,5-2 bevorzugt werden.

Der Polymerisationsinitiator (B), welcher bei Bestrahlung freie Radikale bildet, die den Rest (A) polymerisieren, kann gegen sichtbares oder ultraviolettes Licht empfindlich sein. Solche Initiatoren sind bekannt und umfassen z.B. Benzoinether, Acyloinether, halogenierte Alkyl- oder Arylderivate, aromatische Carbonylderivate, Metallocene, Gemische von organometallischen Verbindungen der Gruppe IVa mit photoreduzierbaren Farbstoffen, Chinone, gegebenenfalls im Gemisch mit aliphatischen Aminen, welche an einem aliphatischen α-Kohlenstoffatom einen Wasserstoffatom haben, aliphatische Dicarbonylverbindungen, die gegebenenfalls mit einem Amin vermischt sind, 3-Ketocumarine, Acylphosphinoxide, Metallcarbonyle und Gemische photoreduzierbarer Farbstoffe mit Reduktionsreagenzien. Bevorzugte Polymerisationsinitiatoren (B) sind Camphorchinon zusammen mit einem tertiären Amin, das ein Wasserstoffatom am aliphatischen α-Kohlenstoffatom hat, wie z.B. Bis(4-dimethylamino)benzophenon und Triethanolamin, Biacetyl, Dimangandecacarbonyl, Benzildimethylketal, Isobutylbenzoinether, 2,2,2-Trichlor-4′-tert.butylacetophenon, Diethoxyacetophenon, Cumarine mit einer carbocyclischen oder heterocyclischen aromatischen Ketogruppe in der 3-Stellung, wie z.B. 3-Benzoyl-7-methoxycumarin, oder 3-(4-Cyanobenzoyl)-5,7-dipropoxycumarin, Gemische von photoreduzierbaren Farbstoffen, wie z.B. Methylenblau oder Bengalrosa mit einem Stannan wie z.B. Trimethylbenzylstannan, Tributylbenzylstannan, Tributyl-4-methylbenzylstannan oder Dibutyldibenzylstannan, Gemische von photoreduzierbaren Farbstoffen mit einem Elektronendonor, wie z.B. Natriumbenzolsulfinat oder Benzolsulfinsäure und ein Titanmetallocen, wie z.B. Bis(π-methylcyclopentadienyl)bis(σ-pentafluorphenyl)titan (IV) oder Bis(π-methylcyclopentadienyl)-bis(σ-hexyloxytetrafluorphenyl)titan (IV).

Es werden auch Gemische beschrieben, in welchen der Initiator (B) ein Metallocen oder ein Gemisch einer organometallischen Verbindung der Gruppe IVa mit photoreduzierbaren Farbstoffen ist, die als solche neu sind. Die vorliegende Erfindung betrifft daher neue Stoffgemische, welche im vorliegenden Verfahren verwendet werden können, enthaltend

(A) einen Rest, der durch freie Radikale polymerisierbar ist,

(B) einen strahlungsaktivierbaren Polymerisationsinitiator für (A), der ein Metallocen oder ein Gemisch einer organometallischen Verbindung der Gruppe IVa mit einem photoreduzierbaren Farbstoff ist, und

(C) einen strahlungssolubilisierbaren Rest, der durch Strahlung verschiedener Wellenlänge als der Initiator (B) aktivierbar ist.

Bevorzugte Metallocene, die in den neuen Stoffgemischen verwendet werden, sind Titanocene der Formel V

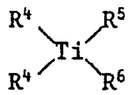

(V) ,

worin jede der Gruppen $R^4$ unabhängig voneinander eine gegebenenfalls substituierte Cyclopentadienyl- oder Indenylgruppe ist, oder die zwei $R^4$-Gruppen zusammen Alkylidengruppen mit 2 bis 12 Kohlenstoffatomen, eine Cycloalkylidengruppe mit 5 bis 7 Kohlenstoffatomen im Ring, eine Gruppe $Si(R^7)_2$ oder $Sn(R^7)_2$, oder eine gegebenenfalls substituierte Gruppe der Formel

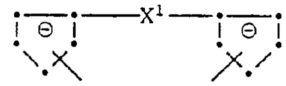

,

worin $X^1$ Methylen, Ethylen oder 1,3-Propylen bedeutet, darstellen, $R^5$ einen 6-gliedrigen carbocyclischen oder 5- oder 6-gliedrigen heterocyclischen aromatischen Ring bedeutet, der in mindestens einer der ortho-Stellungen zur Metall-Kohlenstoffbindung durch ein Fluoratom substituiert ist, wobei der Ring gegebenenfalls weitere Substituenten aufweisen kann, oder $R^5$ mit $R^6$ zusammen eine Gruppe -Q-Y-Q- bedeuten, und Q für einen 5- oder 6-gliedrigen carbocyclischen oder heterocyclischen aromatischen Ring steht, in welchem jede der zwei Bindungen ortho zur Q-Y Bindung ist und jede Stellung meta zur Q-Y Bindung durch Fluor substituiert ist, wobei die Gruppen Q gegebenenfalls weitere Substituenten haben können, Y eine Methylengruppe, eine Alkylidengruppe mit 2 bis 12 Kohlenstoffatomen, eine Cyloalkylidengruppe mit 5 bis 7 Kohlenstoffatomen im Ring, eine direkte Bindung, eine Gruppe $NR^7$, einen Sauerstoff- oder Schwefelatom, eine Gruppe $-SO_2-$, -CO-, $-Si(R^7)_2-$ oder $-Sn(R^7)_2-$ bedeutet, $R^6$ eine Alkinyl- oder Phenylalkinylgruppe, die substituiert sein kann, eine Azido oder Cyanogruppe oder eine Gruppe der Formel $Si(R^7)_2$ oder $Sn(R^7)_2$ oder die gleiche Bedeutung wie die Gruppe $R^5$ hat, und $R^7$ eine Alkylgruppe mit 1 bis 12 Kohlenstoffatomen, eine Cycloalkylgruppe mit 5 bis 12 Kohlenstoffatomen, eine Arylgruppe mit 6 bis 16 Kohlenstoffatomen oder eine Aralkylgruppe mit 7 bis 16 Kohlenstoffatomen ist.

Bei den Gruppen $R^4$ handelt es sich bevorzugt um gleiche Reste. Als Substituenten für durch $R^4$ dargestellte Gruppen kommen in Frage: Lineares und verzweigtes Alkyl, Alkoxy und Alkenyl mit bevorzugt bis zu 18, besonders bis zu 12 und insbesondere bis zu 6 C-Atomen, wie Methyl, Ethyl, Propyl, Isopropyl, n-Butyl, tert.-Butyl, Pentyl, Hexyl, Oxtyl, Decyl, Dodecyl, Tetradecyl, Hexadecyl, Octadecyl und entsprechende Alkenyl- und Alkoxygruppen; Cycloalkyl und Cycloalkenyl mit bevorzugt 5 bis 8 Ringkohlenstoffatomen, wie z.B. Cyclopentyl, Cyclohexyl, Cycloheptyl, Methylcyclopentyl und Methylcycohexyl; Aryl mit bevorzugt 6 bis 16 C-Atomen und Aralkyl mit bevorzugt 7 bis 16 C-Atomen; wie z.B. Phenyl, Naphthyl, Biphenyl, Benzyl und Phenylethyl; Nitril, Halogen, besonders F, Cl und Br, sowie Aminogruppen, besonders tertiäre Aminogruppen, die lineare oder verzweigte Alkylgruppen mit 1 bis 12, besonders 1 bis 6 C-Atomen und insbesondere Methyl und Ethyl, Phenyl und Benzyl enthalten können. Die Aminogruppen können auch quaternisiert sein, besonders mit linearen oder verzweigten Alkylhalogeniden mit vorzugsweise 1 bis 12 C-Atomen, besonders Methyl- oder Ethylhalogeniden; lineares oder verzweigtes Aminoalkyl, besonders tertiäres Aminoalkyl, das auch quaternisiert sein kann, besonders mit Alkylhalogeniden. Die Alkylengruppe im Aminoalkyl kann linear oder vezweigt sein und enthält bevorzugt 1 bis 12, insbesondere 1 bis 6 C-Atome und ist ganz besonders $\alpha$-verzweigtes Alkyl mit 1-12 C-Atomen.

Die Reste $R^4$ können bis zu 3, besonders aber 1, Substituenten enthalten. Insbesondere sind beide $R^4$ Cyclopentadienyl$^{\ominus}$ oder Methycyclopentadienyl$^{\ominus}$.

Alkylidengruppen $X^1$ und Y enthalten bevorzugt 2 bis 6 C-Atome. Beispiele für Alkylidengruppen und Cycloalkylidengruppen $X^1$ und Y sind Ethyliden, 2,2-Propyliden, Butyliden, Hexyliden, Phenylmethylen, Diphenylmethylen, Cyclopentyliden und Cyclohexyliden. Besonders bevorzugt ist $X^1$ Methylen. $R^7$ in seiner Bedeutung als Alkyl enthält bevorzugt 1 bis 6 C-Atome und ist z.B. Methyl, Ethyl, Propyl, Butyl oder Hexyl. In seiner Bedeutung als Cycloalkyl ist $R^7$ bevorzugt Cyclopentyl oder Cyclohexyl, in seiner Bedeutung als Aryl bevorzugt Phenyl und in seiner Bedeutung als Aralkyl bevorzugt Benzyl.

Der Rest $R^5$ ist bevorzugt in beiden Orthostellungen durch Fluor substituiert.

Bei $R^5$ in seiner Bedeutung als carbocyclischer aromatischer und fluor-substituierter Ring kann es sich um Inden, Indan, Fluoren, Naphthalin und besonders Phenyl handeln. Beispiele sind: 4,6-Difluorinden-5-yl, 5,7-Difluorinden-6-yl, 2,4-Difluorfluoren-3-yl, 1,3-Difluornaphth-2-yl und besonders 2,6-Difluorphen-1-yl.

$R^5$ als heterocyclischer aromatischer und 5-gliedriger Ring enthält bevorzugt ein Heteroatom und als 6-gliedriger Ring bevorzugt 1 oder 2 Heteroatome. Beispiele für solche mit 2-Fluoratomen substituierte Ringe sind: 2,4-Difluorpyrrol-3-yl, 2,4-Difluorfur-3-yl, 2,4-Difluorthiophen-3-yl, 2,4-Difluorpyrid-3-yl, 3,5-Difluorpyrid-4-yl und 4,6-Difluorpyrimid-5-yl.

$R^5$ und $R^6$ zusammen als Gruppe -Q-Y-Q- können z.B. sein:

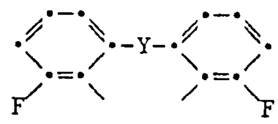 , 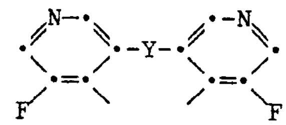 ,

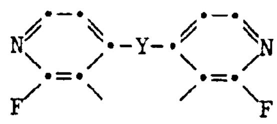 , 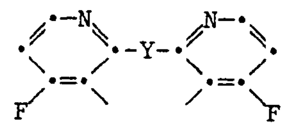 ,

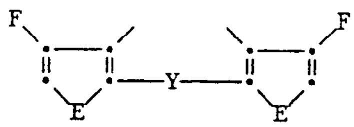 und 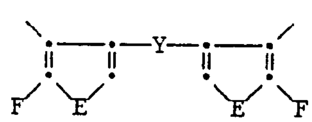 ,

worin E O, S oder NH darstellt. Y ist bevorzugt Methylen, Ethyliden, 2,2-Propyliden, eine direkte Bindung oder O.

Die Reste $R^5$ sowie die Gruppen Q in -Q-Y-Q- können teilweise oder vollständig durch weitere Gruppen substituiert sein. Geeignete Gruppen sind: Lineares oder verzweigtes Alkyl oder Alkoxy mit bevorzugt 1 bis 18, insbesondere 1 bis 6 C-Atomen, z.B. Methyl, Ethyl, Propyl, Butyl, Phenyl, Hexyl und die entsprechenden Alkoxygruppen, besonders Methoxy und Hexyloxy; Cycloalkyl mit bevorzugt 5 oder 6 Ringkohlenstoffatomen, Aryl mit bevorzugt 6 bis 16 C-Atomen und Aralkyl mit bevorzugt 7 bis 16 C-Atomen, wie z.B. Cyclopentyl, Cyclohexyl, Phenyl oder Benzyl; Hydroxyl, Carboxyl, CN, Halogen, wie F, Cl oder Br, und Aminogruppen, besonders tertiäre Aminogruppen, die mit Alkylhalogeniden, wie Methylchlorid, - bromid oder -iodid, quaternisiert sein können. Beispiele für Aminogruppen sind Methylamino, Ethylamino, Dimethylamino, Diethylamino, Pyrrolidyl, Piperidyl, Piperazyl, Morpholyl und N-Methylpiperazyl; Alkoxycarbonyl mit bevorzugt 1 bis 18, besonders 1 bis 6 C-Atomen in der Alkoxygruppe, Aminocarbonyl mit ein oder zwei Alkylgruppen mit 1 bis 12 C-Atomen in der Aminogruppe, oder Aminocarbonyl mit heterocyclischen Aminen, wie Pyrrolidin, Piperidin, Piperazin, N-Methylpiperazin und Morpholin; Aminoalkyl, besonders tertiäres Aminoalkyl mit bevorzugt $C_1$-$C_6$-Alkylgruppen, das mit Alkylhalogeniden quaternisiert sein kann. Bevorzugt ist Tertiäraminoalkyl, das durch Alkyl mit 1 bis 6 C-Atomen substituiert sein kann. Beispiele sind Dimethylaminomethyl und (Trimethylammonium-methyl)iodid.

Stellt $R^6$ Alkinyl dar, so handelt es sich z.B. um 2-Butinyl und vor allem um Propargyl.

Substituenten für $R^6$ als Phenylalkinyl sind z.B. Halogen, wie F, Cl und Br, Alkyl und Alkoxy mit 1-6 C-Atomen, -COOH-, -OH und -CN. $R^6$ hat bevorzugt die Bedeutung von $R^5$.

In einer bevorzugten Ausführungsform sind $R^5$ und $R^6$ in Formel V unsubstituiertes oder substituiertes 2,6-Difluorphen-1-yl oder $R^5$ und $R^6$ bilden zusammen einen Rest der Formel

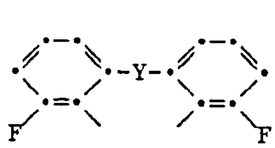 ,

worin Y die oben angegebene Bedeutung hat und insbesondere eine direkte Bindung, $CH_2$ oder O ist.

Eine bevorzugte Gruppe von Metallocenen der Formel V sind solche, worin beide $R^4$ $\pi$-Cyclopentadienyl oder durch $C_1$-$C_4$-Alkyl, besonders Methyl, substituiertes $\pi$-Cyclopentadienyl und $R^5$ und $R^6$ je ein Rest der Formel Va

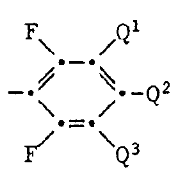 Va

sind, worin $Q^1$, $Q^2$ und $Q^3$ unabhängig voneinader für ein Wasserstoffatom, F, Cl, Br oder eine tertiäre Aminogruppe, besonders eine Morpholinogruppe oder eine Alkoxygruppe, besonders eine Methoxy- oder Hexyloxygruppe, stehen. Die Amino- oder Alkoxygruppe ist bevorzugt in para-Stellung zur freien Bindung gebunden. Eine bevorzugte Untergruppe sind Metallocene der Formel V, worin beide $R^4$ $\pi$-Methylcyclopentadienyl oder $\pi$-Cyclopentadienyl darstellen und $R^5$ und $R^6$ je ein Rest der Formel Va sind, worin $Q^1$ und $Q^3$ für H, F, Cl oder Br und $Q^2$ für H, F oder Alkoxy stehen. Besonders bevorzugt sind $Q^1$ und $Q^3$ unabhängig voneinander ein Wasserstoff- oder Fluoratom und $Q^2$ ist ein Fluoratom oder ein Hexyloxyrest.

Verbindungen der Formel V sowie deren Herstellung sind in der U.S. Patentschrift No. 4,590,287 beschrieben.

Bevorzugte organometallische Verbindungen der Gruppe IVA, welche in den neuen Stoffgemischen verwendet werden, sind Organostannane der Formel VI

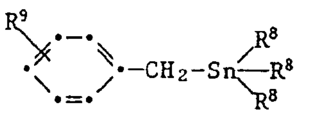 (VI),

worin $R^8$ eine Alkylgruppe mit 1 bis 4 Kohlenstoffatomen oder eine Alkenyl- der Alkynylgruppe mit 2 bis 4 Kohlenstoffatomen und $R^9$ ein Wasserstoff- oder Halogenatom oder eine Alkyl- oder Alkoxygruppe mit 1 bis 4 Kohlenstoffatomen sind.

Bevorzugte Verbindungen der Formel VI sind jene, worin $R^8$ eine Alkylgruppe mit 1 bis 4 Kohlenstoffatomen und $R^9$ ein Wasserstoffatom oder eine Alkylgruppe mit 1 bis 4 Kohlenstoffatomen bedeuten.

Diese Organostannane werden durch eine Grignard Verknüpfung eines Benzylmagnesiumhalogenids mit einem Trialkylzinnhalogenid in einem inerten Lösungsmittel hergestellt, gefolgt von Filtration, Waschen mit Wasser und Destillation des Produkts.

Bevorzugte photoreduzierbare Farbstoffe, welche mit diesen Organostannanen verwendet werden, sind Methylenblau und Bengalrosa.

Verbindungen mit kationisch polymerisierbaren Gruppen (A), die in der flüssigen Zusammensetzung, wie oben definiert, eingesetzt werden können, sind an sich bekannt. Dabei kann es sich beispielsweise um eine kationisch polymerisierbare heterocyclische Verbindung handeln, beispielsweise um einen cyclischen Ether, wie ein Oxetan oder ein Tetrahydrofuran, oder um einen cyclischen Ester, beispielsweise ein Lacton oder um ein Episulfid, beispielsweise Ethylensulfid. Vorzugsweise ist (A) ein 1,2-Epoxid, ein Vinylether oder eine Mischung dieser Verbindungstypen. Geeignete 1,2-Epoxide umfassen Ethylenoxid, Propylenoxid und Epichlorhydrin. Zu den bevorzugten 1,2-Epoxiden zählen Glycidylether von Alkoholen oder Phenolen, insbesondere einwertigen Alkoholen oder Phenolen, beispielsweise n-Butylglycidylether, n-Octylglycidylether, Phenylglycidylether oder Kresylglycidylether, oder cycloaliphatische Epoxide, beispielsweise Monoepoxide, wie $\alpha$-Pinenoxid, Epoxidharze, wie 3,4-Epoxycyclohexylmethyl-3′,4′-epoxycyclohexan-carboxylat oder dessen 6,6′-Dimethylderivat, oder Glycidylester, insbesondere solche von Monocarbonsäuren, wie Propionsäure, Cyclohexancarbonsäure oder Benzoesäuren. Geeignete Vinylether sind z.B. cyclische Vinylether, welche einen Dihydropyranrest enthalten, und insbesondere Vinyloxyalkylether von Alkoholen und Phenolen.

Als kationische Photoinitiatoren für Komponente (A) kommt eine Vielzahl von Verbindungen in Frage. Der Initiator (B) für kationisch polymerisierbare Reste (A) kann z.B. mindestens eine Verbindung der Formel VII sein,

$$[R^{10}]^{+an}\ \frac{an}{q}\ [LT_m]^{-q} \qquad (VII),$$

worin L ein zweiwertiges bis siebenwertiges Metall oder Nichtmetall ist, T ein Halogenatom bedeutet oder einer der Reste T auch eine Hydroxylgruppe sein kann, q eine ganze Zahl von 1 bis 3 ist, m eine ganze Zahl ist, die der Wertigkeit von L+q entspricht, a 1 oder 2 ist und n eine ganze Zahl von 1 bis 3 bedeutet und $R^{10}$ ein Ion ist, das ausgewählt wird aus der Gruppe bestehend aus

(i) aromatischen Iodoniumionen, im allgemeinen der Formel

$$Ar\text{-}I^{+}\text{-}Ar' ,$$

worin Ar und Ar′ substituierte oder unsubstituierte aromatische Reste sind,

(ii) $[G\text{-}Z\text{-}(CO)_x]^+$ , worin G ein Aren oder eine Dienyliumgruppe ist, Z ein Atom eines d-Block Uebergangselementes ausgewählt aus der Gruppe bestehend aus Titan, Vanadium, Chrom, Mangan, Eisen, Kobalt,

Nickel, Kupfer, Niob, Molybdän, Ruthenium, Rhodium, Palladium, Silber, Tantal, Wolfram, Rhenium, Osmium, Iridium, Platin oder Gold ist, und x eine positive ganze Zahl bedeutet, so dass Z eine geschlossene Elektronenkonfiguration aufweist.

(iii) aromatische Diazonium Ionen,

(iv) $[(R^{11})(R^{12}M)_a]^{+an}$ ,

worin a und n die oben definierte Bedeutung besitzen, M das Kation eines einwertigen bis dreiwertigen Metalls aus den Gruppen IVb bis VIIb, VIII oder Ib des Periodensystems ist, $R^{11}$ ein $\pi$-Aren ist und $R^{12}$ ein $\pi$-Aren oder das Anion eines $\pi$-Arens bedeutet,

(v) Sulfoniumionen,

(vi) Sulfoxoniumionen, und

(vii) Iodosylionen.

Handelt es sich bei $R^{10}$ um ein Iodoniumion, so besitzt der Initiator vorzugsweise die Formel VIII

$$[Ar_h\text{-}I\text{-}Ar'_i]_j^+ [LT_m]^{-(k-1)} \qquad \text{(VIII)},$$

worin Ar ein einwertiger aromatischer Rest ist, Ar' ein zweiwertiger aromatischer Rest ist, h Null oder 2, i Null oder 1 und die Summe h+i 2 oder gleich der Wertigkeit von I ist, j den Wert k-1 hat und 1 die Wertigkeit von L bedeutet, k eine ganze Zahl von 2 bis 8 ist und L, T und m die weiter oben definierten Bedeutungen besitzen.

Die Reste Ar in Formel VIII können gleich oder unterschiedlich sein. Dabei handelt es sich in der Regel um carbocyclisch-aromatische oder heterocyclisch-aromatische Gruppen mit 5 bis 20 C-Atomen, die mit ein bis vier einwertigen Resten, vorzugsweise $C_1$-$C_8$Alkoxy, $C_1$-$C_8$Alkyl, Nitro oder Chlor substituiert sein können. Ar ist vorzugsweise Phenyl, Chlorphenyl, Nitrophenyl, Methoxyphenyl oder Pyridyl. Von Ar' umfasste Arylenreste sind vorzugsweise $C_{12}$-$C_{20}$ zweikernige Reste wie z.B.

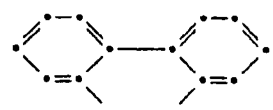 oder 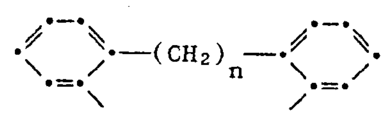 ,

worin n 1-3, vorzugsweise 1 oder 2, ist.

Die Iodoniumsalze werden in der Regel zusammen mit einem Farbstoff als Sensibilisator eingesetzt, wenn (B) durch sichtbares Licht aktiviert werden soll.

Zu den Farbstoffen, die in Kombination mit den oben definierten Aryliodoniumsalzen eingesetzt werden können, zählen im Rahmen dieser Erfindung kationische Farbstoffe, beispielsweise die Verbindungen, die in Kirk-Othmer Encyclopedia, 2. Ausgabe, Vol. 20, 194-7 (1969), Johen Wiley & Sons, New York, beschrieben sind.

Einige ausgewählte Vertreter sind beispielsweise die folgenden Verbindungen:

- Acridin Orange; C.I. 46005
- Acridin Gelb; C.I. 46035
- Phosphin R; C.I. 46045
- Benzoflavin; C.I. 46065
- Setoflavin T; C.I. 49005.

Zusätzlich zu den oben erwähnten Farbstofftypen können auch basische Farbstoffe eingesetzt werden. Einige dieser Verbindungen werden in Kirk-Othmer Encyclopedia, Vol. 7, 532-4 (1969) beschrieben und umfassen

Hemaporphyrin,

4,4'-Bisdimethylaminobenzophenon und

4,4'-Bisdiethylaminobenzophenon.

Handelt es sich bei $R^{10}$ um ein Kation (ii), so besitzt der Initiator beispielsweise die Formel IX

$$[G\text{-}Z\text{-}(CO)_x]^+ [LT_m]^- \qquad \text{(IX)},$$

worin G, Z, x, L, T und m die weiter oben definierte Bedeutung besitzen.

Wenn G eine Arengruppe bedeutet, d.h. selbst ein 6-Elektronenligand ist, so kann es eine einkernige oder mehrkernige Gruppe, einschliesslich einer kondensierten Ringgruppe, sein. Vorzugsweise ist es eine gegebenenfalls durch eine oder mehrere Alkoxygruppen substituierte Kohlenwasserstoffgruppe und enthält vorzugsweise 6 bis 18 Kohlenstoffatome, wie Benzol, Toluol, Mesitylen, Naphthalin, Biphenyl, Phenanthren, Fluoren und Anthracen.

Wenn G eine Dienyliumgruppe bedeutet, so ist es vorzugsweise eine cyclische Gruppe einer der folgenden Formeln

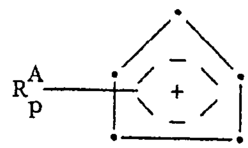 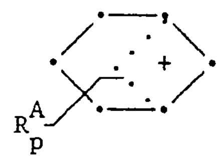 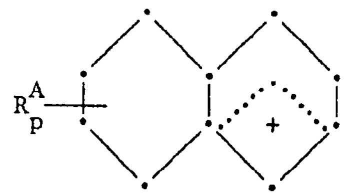

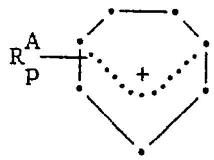 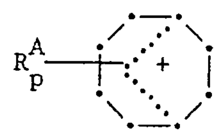

worin $R^A$ für eine Alkylgruppe mit 1 bis 4 Kohlenstoffatomen, eine Alkoxygruppe mit 1 bis 4 Kohlenstoffatomen oder eine durch eine oder mehrere Oxycarbonylgruppen unterbrochene Alkylgruppe mit bis zu 12 Kohlenstoffatomen steht und p null, 1, 2 oder 3 ist.

Z steht vorzugsweise für Chrom, Kobalt, Nickel und insbesondere Eisen oder Mangan.

Besonders bevorzugte einzelne Salze der Formel IX, worin G eine Arengruppe bedeutet, sind unter anderem die Hexafluorophosphate des $\pi$-Toluoltricarbonylmangans, $\pi$-Benzoltricarbonylmangans, $\pi$-Mesitylentricarbonylmangans, $\pi$-1-Methyl-5,6,7,8-tetrahydronaphthalintricarbonylmangans, $\pi$-Hexylbenzoltricarbonylmangans, $\pi$-Methoxybenzoltricarbonylmangans und $\pi$-Hexyloxybenzoltricarbonylmangans.

Diese Salze erfüllen die Forderung, dass das Zentralatom (Mangan) eine geschlossene Elektronenschalenkonfiguration besitzt, d.h. 18 Elektronen in seiner Valenzschale, wobei einwertiges Mangan mit seinem einfach positiven Kation 6 Elektronen, die Arengruppe 6 Elektronen und die drei Carbonylgruppen je 2 Elektronen beisteuern.

Salze der Formel IX, worin G eine Aren- oder Dienyliumgruppe bedeutet, sind allgemein bekannt und können beispielsweise, wie in der EP-A 94,914 beschrieben, hergestellt werden

Besonders bevorzugte einzelne Salze der Formel IX, worin G eine cyclische Dienyliumgruppe bedeutet, sind unter anderem Tricarbonyl(cyclohexa-1,3-dienylium)eisen-tetrafluoroborat, Tricarbonyl(1-methylcyclohexa-2,4-dienylium)eisen-hexafluorophosphat, Tricarbonyl(1-methyl-4-methoxy-cyclohexa-2,4-dienylium)eisen-hexafluorophosphat, Tricarbonyl)2-methoxybicyclo[4.4.0]deca-2,4-dienylium)eisen-hexafluorophosphat, Tricarbonyl(1-(acetoxymethyl)-2-(methoxy-carbonylacetoxy)ethylcyclohexa-2,4-dienylium)eisen-hexafluorophosphat, Tricarbonyl(1-ethyl-4-isopropoxycyclohexa-2,4-dienylium)eisenhexafluorophosphat, Tricarbonyl(1-methoxycarbonyl)-4-methoxycyclohexa-2,4-dienylium)eisen-tetrafluoroborat und ($\pi$-Cyclohexadienyl)tricarbonyleisen-hexafluoroarsenat.

Diese Salze erfüllen ebenfalls die Forderung, dass das Zentralatom (Eisen) eine geschlossene Elektronenschalenkonfiguration besitzt, wobei das Eisen 7 Elektronen, die Dienyliumgruppe 5 und die Carbonylgruppen ebenfalls je 2 Elektronen (d.h. insgesamt 18) beisteuern.

Handelt es sich bei $R^{10}$ um ein aromatisches Diazoniumion, so sind die aromatischen Reste unsubstituiert oder substituiert, beispielsweise durch einen oder mehrere Reste ausgewählt aus der Gruppe bestehend aus Arylthio, Aryloxy, Dialkylamino, Alkyl oder Alkoxy.

Handelt es sich bei $R^{10}$ um ein Metalloceniumion, so besitzt der Inititaotr vorzugsweise die Formel X

$$[(R^{11})(R^{12}M)_a]^{+an} \frac{an}{q} [LT_m]^{-q} \qquad (X),$$

worin a 1 oder 2 sowie n and q unabhängig voneinander je eine gazne Zahl von1 bis 3 sind, M, L, T und m die weiter oben definierte Bedeutung besitzen, $R^{11}$ ein $\pi$-Aren und $R^{12}$ ein $\pi$-Aren oder das Anion eines $\pi$-Arens bedeuten.

Als $\pi$-Arene $R^{11}$ und $R^{12}$ kommen insbesondere aromatische Gruppen mit 6 bis 24 Kohlenstoffatomen oder heteroaromatische Gruppen mit 3 bis 30 Kohlenstoffatomen in Betracht, wobei diese Gruppen gegebenenfalls durch gleiche oder verschiedene einwertige Reste wie Halogenatome, vorzugsweise Chlor- oder Bromatome, oder $C_1$-$C_8$-Alkyl, $C_1$-$C_8$-Alkoxy-, Cyano-, $C_1$-$C_8$-Alkylthio-, $C_2$-$C_6$-Monocarbonsäurealkylester-, Phenyl-, $C_2$-$C_5$-Alkanoyl- oder Benzoylgruppen einfach oder mehrfach substituiert sein können. Diese $\pi$-Arengruppen können einkernige, kondensierte mehrkernige oder unkondensierte mehrkernige Systeme darstellen, wobei in den zuletzt genannten Systemen die Kerne direkt oder über Brückenglieder wie -S-, -O- oder -C=C- verknüpft

sein können.

$R^{12}$ als das Anion eines π-Arens kann ein Anion eines π-Arens der obengenannten Art sein, zum Beispiel das Indenylanion und insbesondere das Cyclopentadienylanion, wobei auch diese Anionen gegebenenfalls durch gleiche oder verschiedene einwertige Reste wie $C_1$-$C_8$-Alkyl, $C_2$-$C_6$-Monocarbonsäurealkylester-, Cyano-, $C_2$-$C_5$-Alkanoyl oder Benzoylgruppen einfach oder mehrfach substituiert sein können.

Die Alkyl-, Alkoxy-, Alkylthio-, Monocarbonsäurealkylester- und Alkanoylsubstituenten können dabei geradkettig oder verzweigt sein. Als typische Alkyl-, Alkoxy-, Alkylthio-, Monocarbonsäurealkylester- bzw. Alkanoylsubstituenten seien Methyl, Ethyl, n-Propyl, Isopropyl, n-Butyl, sek.-Butyl, tert.-Butyl, n-Pentyl, n-Hexyl und n-Octyl, Methoxy, Ethoxy, n-Propoxy, Isopropoxy, n-Butoxy, n-Hexyloxy und n-Octyloxy, Methylthio, Ethylthio, n-Propylthio, Isopropylthio, n-Butylthio, n-Pentylthio und n-Hexylthio, Carbonsäuremethyl und -n-pentylester bzw. Acetyl, Propionyl, Butyryl und Valeroyl genannt. Dabei sind Alkyl-, Alkoxy-, Alkylthio- und Monocarbonsäurealkylestergruppen mit 1 bis 4 und insbesondere 1 oder 2 Kohlenstoffatomen in den Alkylteilen sowie Alkanoylgruppen mit 2 oder 3 Kohlenstoffatomen bevorzugt. Als substituierte π-Arene oder Anionen von substituierten π-Arenen werden solche bevorzugt, die einen oder zwei der obengenannten Substituenten, insbesondere Chlor- oder Bromatome, Methyl-, Ethyl-, Methoxy-, Ethoxy-, Cyano-, Carbonsäuremethyl- oder -ethylestergruppen und Acetylgruppen, enthalten.

Als $R^{11}$ und $R^{12}$ können gleiche oder verschiedene π-Arene vorliegen. Als heteroaromatische π-Arene eignen sich S-, N- und/oder O-Atome enthaltende Systeme. Heteroaromatische π-Arene, die S- und/oder O-Atome enthalten, sind bevorzugt. Beispiele für geeignete π-Arene sind Benzol, Toluol, Xylole, Ethylbenzol, Cumol, Methoxybenzol, Ethoxybenzol, Dimethoxybenol, p-Chlortoluol, Chlorbenzol, Brombenzol, Dichlorbenzol, Acetylbenzol, Trimethylbenzol, Trimethoxybenzol, Naphthalin, 1,2-Dihydronaphthaline, Methoxynaphthaline, Ethoxynaphthaline, Chlornaphthaline, Bromnaphthaline, Biphenyl, Stilben, Inden, Biphenylen, Fluoren, Phenanthren, Anthracen, 9,10-Dihydroanthracen, Triphenylen, Pyren, Perylen, Naphthacen, Coronen, Thiophen, Chromen, Xanthen, Thioxanthen, Benzothiophen, Naphthothiophen, Thianthren, Diphenylenoxyd, Diphenylensulfid, Acridin und Carbazol.

Wenn a 2 ist, stellt $R^{12}$ vorzugsweise das Anion eines π-Arens dar, und M ist jeweils das gleiche Metallatom. Beispiele für Anionen substituierter π-Arene sind die Anionen des Methyl-, Ethyl-, n-Propyl- und n-Butylcyclopentadiens, die Anionen des Dimethylcyclopentadiens, der Cyclopentadiencarbonsäuremethyl- und -ethylester sowie des Acetylcyclopentadiens, Propionylcyclopentadiens, Cyancyclopentadiens und Benzoylcyclopentadiens. Bevorzugte Anionen sind das Anion des unsubstituierten Indens und insbesondere des unsubstituierten Cyclopentadiens.

Bevorzugt hat a den Wert 1, und $R^{11}$ steht für Benzol, Toluol, Xylol, Cumol, Methoxybenzol, Chlorbenzol, p-Chlortoluol, Naphthalin, Methylnaphthalin, Chlornaphthalin, Methoxynaphthalin, Biphenyl, Inden, Pyren, oder Diphenylensulfid, und $R^{12}$ steht für das Anion des Cyclopentadiens, Acetylcyclopentadiens oder Indens oder für Benzol, Toluol, Xylol, Trimethylbenzol, Naphthalin oder Methylnaphthalin.

Besonders bevorzugt sind solche Komplexe der Formel X, worin a 1 ist, $R^{11}$ für Cumol, $\eta^6$-Pyren oder $\eta^6$-Naphthalin und $R^{12}$ für das Anion des $\eta^5$-Cyclopentadiens stehen, n vorzugsweise 1 oder 2, insbesondere 1, und q vorzugsweise 1 sind.

M ist beispielsweise $Ti^+$, $Ti^{2+}$, $Ti^{3+}$, $Zr^+$, $Zr^{2+}$, $Zr^{3+}$, $Hf^+$, $Hf^{2+}$, $Hf^{3+}$, $Nb^+$, $Nb^{2+}$, $Nb^{3+}$, $Cr^+$, $Mo^+$, $Mo^{2+}$, $W^+$, $W^{2+}$, $Mn^+$, $Mn^{2+}$, $Nm^{2+}$, $Re^+$, $Fe^{2+}$, $Co^{2+}$, $Co^{3+}$, $Ni^{2+}$ oder $Cu^{2+}$. Vorzugsweise ist M ein Chrom-, Kobalt-, Mangan-, Wolfram- oder Molbydänkation, insbesondere ein Eisenkation, und ganz besonders bevorzugt $Fe^{2+}$.

Die Verbindungen der Formel X lassen sich nach an sich bekannten Methoden herstellen, zum Beispiel, wie in der EP-A 94,915 beschrieben, durch Umsetzung einer Verbindung der Formel XI

$$[(R^{11})(R^{12}M)_a]^{+an} \quad \frac{an}{q} \; [X]^{-q} \qquad (XI)$$

mit einem Salz eines Anions $[LT_m]^{-q}$, worin a, m, n, q, $R^{11}$, $R^{12}$, M und L die unter der Formel X angegebenen Bedeutungen haben und $[X]^{-q}$ ein von $[LT_m]^{-q}$ verschiedenes Anion darstellt.

Sowohl die Verbindungen der Formel XI als auch die Verbindungen der Formel XII

$$[(R^{11'})(R^{12}M)_a] \qquad (XII)$$

worin a und M die oben angegebenen Bedeutungen haben und $R^{11'}$ ein π-Aren oder das Anion eines π-Arens und $R^{12}$ ein Anion eines π-Arens darstellen, lassen sich durch Umsetzung gleicher oder verschiedener π-Arene in Gegenwart einer Lewis-Säure mit einem Salz eines Metalls aus Gruppe IVb bis VIIb, VIII oder Ib des Periodensystems herstellen. Die Verbindungen der Formeln X, XI und XII eignen sich auch zur Durchführung eines Ligandenaustausches, indem man diese Verbindungen in Gegenwart einer Lewis-Säure mit einem von $R^{11}$ und-/oder $R^{12}$ bzw. $R^{11'}$ verschiedenen π-Aren umsetzt. In diesen Fällen ist n vorzugsweise 2 und besonders bevorzugt 1.

Verbindungen der Formel X, worin L ein Metall ist, lassen sich auch durch Umsetzung gleicher oder verschiedener π-Arene in Gegenwart einer Lewis-Säure mit einem geeigneten Salz eines Metalls aus Gruppe IVb bis VIIb, VIII oder Ib des Periodensystems, z.B. einem Titan-, Zirkon-, Chrom-, Mangan- und insbesondere einem Eisensalz, herstellen. Schliesslich kann man auch Verbindungen der Formel X in herkömmlicher Weise durch Anionenaustausch in Komplexe der Formel X mit einem verschiedenen Anion $[LT_m)^{-q}$ umwandeln.

Bei einer bevorzugten Ausführungsform werden ungeladene π-Komplexe der Formel XII, z.B. Ferrocen oder Bis-($\eta^5$-indenyl)-eisen(II) als Ausgangsstoffe eingesetzt, und diese werden durch Ligandenaustausch in einen Komplex der Formel XI umgewandelt, der anschliessend mit einem Salz eines Anions $[LT_m]^{-q}$ zur Reaktion gebracht wird. Der dabei als Zwischenprodukt erhaltene Komplex der Formel XI wird üblicherweise nicht isoliert.

Als Salze von Anionen $[LT_m]^{-q}$ eignen sich beispielsweise Alkali-, Erdalkali- oder Ammoniumsalze. Es wird bevorzugt, Alkalisalze und besonders bevorzugt Natrium- und Kaliumsalze zu verwenden.

Als Lewis-Säuren für die oben beschriebenen Reaktionen eignen sich beispielsweise $AlCl_3$, $AlBr_3$, $BF_3$, $SnCl_4$ und $TiCl_4$, wobei $AlCl_3$ bevorzugt wird. Es kann vorteilhaft sein, die Ligandenaustauschreaktionen unter Zusatz eines Reduktionsmittels, z.B. Aluminium oder Magnesium, zum Reaktionsgemisch durchzuführen, oder nachträglich dem Reaktionsgemisch ein Reduktionsmittel, z.B. $Na_2SO_3$ oder Ascorbinsäure, zuzusetzen. Aluminium wird als Reduktionsmittel bevorzugt. Die Ligandenaustauschreaktionen werden zweckmässig in einem inerten organischen Lösungsmittel durchgeführt. Geeignete Lösungsmittel sind beispielsweise aliphatische oder cycloaliphatische Kohlenwasserstoffe wie Octan, Nonan, Decan oder Cyclohexan. Gewünschtenfalls kann man auch einen Ueberschuss π-Aren als Lösungsmittel einsetzen.

Die Umsetzung der Verbindungen der Formel XI mit einem Salz eines Anions $[LT_m]^{-q}$ und die Anionenaustauschumwandlung von Verbindungen der Formel X werden zweckmässig in einem wässrigen oder wässrigalkoholischen Medium durchgeführt, z.B. in Gemischen aus Wasser und Methanol oder Ethanol. Die Salze der Anionen $[LT_m]^{-q}$ werden in mindestens stöchiometrischen Mengen, aber vorzugsweise im Ueberschuss eingesetzt.

Beispiele für geeignete Metalle oder Nichtmetalle L im Anion $[LT_M]^{-q}$ der oben erwünschten Verbindungen sind Sb, Fe, Sn, Bi, Al, Ga, In, Ti, Zr, Sc, V, Cr, Mn und Cu; Lanthaniden wie Ce, Pr und Nd oder Actiniden wie Th, Pa, U oder Np. Geeignete Nichtmetalle sind insbesondere B, P und As. L ist vorzugsweise P, As, B oder Sb, wobei P und Sb besonders bevorzugt werden.

Komplexe Anionen $[LT_m]^{-q}$ sind beispielsweise $BF_4^-$, $PF_6^-$, $AsF_6^-$, $SbF_6^-$, $SbF_5(OH)^-$, $FeCl_4^-$, $SnCl_6^{2-}$, $SbCl_6^-$ und $BiCl_6^-$. Die besonders bevorzugten komplexen Anionen sind $SbF_6^-$, $BF_4^-$, $AsF_6^-$ und $PF_6^-$.

Wenn eine Verbindung der Formel X als Polymerisationsinitiator verwendet wird, kann sie zusammen mit einem organischen Peroxid oder Hydroperoxid oder einem Chinon eingesetzt werden.

Eine Vielzahl von organischen Peroxiden eignet sich für diesen Einsatz, beispielsweise 2,5-Dimethyl-2,5-bis-(benzoylperoxy)-hexan, 2,5-Dimethyl-2,5-bis-(tert.butylperoxy)-hexan, Di-tert.butylperoxid, Dihexylenglykolperoxid, tert.Butylcumylperoxid, Isobutylmethylketonperoxid und auch Persäuren und Perester, wie z.B. Perbenzoesäure, tert.Butylperacetat, tert.Butylperbenzoat und tert.Butylperphthalat.

Man kann auch organische Hydroperoxide verwenden. Beispiele dafür sind Alkyl-, Aryl- oder Aralkylhydroperoxide mit bis zu 18 C-Atomen. Dazu zählen vorzugsweise Methylethylketonhydroperoxid, tert.Butylhydroperoxid, Cumolhyderperoxid und Hydroperoxide, die durch Oxygenierung von Keten oder Cyclohexen erhältlich sind. Besonders wirksam sind tert.Butylhydroperoxid und Cumolhydroperoxid.

Als Chinon lässt sich bevorzugt Benzochinon einsetzen.

Geeignete Polymerisationsinitiatoren (B) für kationisch polymerisierbre Reste (A) umfassen Oniumsalze und Iodosylsalze. Oniumsalze und Iodosylsalze, welche zusammen mit Epoxidharzen und/oder einem anderen kationisch polymerisierbaren Material photopolymerisierbare Gemische ergeben, sind wohlbekannt. Geeignete Oniumsalze sind z.B. die in den U.S. Patentschriften 4,058,400 und 4,058,401 beschriebenen Verbindungen. Für die gleiche Verwendung geeignete Sulfoxoniumsalze sind z.B. die in den U.S. Patentschriften 4,299,938, 4,339,567, 4,383,025 und 4,398,014 beschriebenen Verbindungen. Für diesen Zweck geeignete aliphatische und cycloaliphatische Sulfoxoniumsalze sind z.B. in der EP-A 164,314 beschrieben. Geeignete für diesen Zweck einsetzbare aromatische Iodoniumsalze umfassen Verbindungen, die in den GB 1,516,351 und 1,539,192 beschrieben sind. Aromatische Iodosylsalze, welche verwendet werden können, umfassen in der U.S. 4,518,676 beschriebene Verbindungen.

Dem Fachmann auf dem Gebiet der Photopolymerisation ist bekannt, dass unter den oben erwähnten Initiatoren (B) ein Teil im, oder nahe dem sichtbaren Bereich des Spektrums, und andere bei Bestrahlung mit ultravioletten Strahlen kürzerer Wellenlänge besser verwendbar sind. Die Wahl von (B) wird davon abhängen, ob (A) bei längerer oder kürzerer Wellenlänge polymerisiert wird als (C) solubilisiert wird, sowie von der spezifischen Wellenlänge bei der (C) solubilisiert wird. Diese Wahl kann durch einfache Versuche vorgenommen

werden.

Die flüssigen Stoffgemische können auch eine mit dem kationisch polymerisierbaren Material (A) copolymerisierbare Hydroxylverbindung, z.B. ein Diol, wie Diethylenglykol oder 1,4-Butandiol, enthalten.

Bei flüssigen Stoffgemischen, welche einen kationisch polymerisierbaren Rest (A) und einen Initiator (B) für (A) enthalten, insbesondere bei Verwendung von Metalloceniumionen der Formel $[(R^{11})(R^{12}M)_a]^{+an}$, kann es nützlich sein, falls kein Peroxid, Hydroperoxid oder Chinon anwesend ist, nach der Bestrahlung in der Stufe (ii) das Stoffgemisch zu erhitzen, um eine vollständige Polymerisierung zu einem klebfreien, festen Zustand zu erreichen. Man kann bis zu 30 Minuten bei Temperaturen bis zu 150°C erhitzen, aber im allgemeinen genügt ein Erhitzen von höchstens 10 Minuten bei 80 bis 120°C.

Photosolubilisierbare Stoffe, welche als (C) verwendet werden können umfassen o-Nitrobenzaldehyd, die in der U.S. 3,991,033 beschriebenen Polyoxymethylenpoylmere, die in der U.S. 3,849,137 beschriebenen o-Nitrocarbinolester, die in der U.S. 4,086,210 beschriebenen o-Nitrophenylacetale, deren Polyesterderivate und endverkappte Derivate, sowie in der U.S. 4,368,253 beschriebene Sulfonatester aromatischer Alkohole, die eine Carbonylgruppe in der $\alpha$- oder $\beta$-Stellung zur Sulfonatestergruppe enthalten, N-Sulfonyloxyderivate eines aromatischen Amids oder Imids, aromatische Oximsulfonate, Chinondiazide und Benzoingruppen in der Kette enthaltende Harze.

Bevorzugte als Rest (C) verwendbare photosolubilisierbare Stoffe sind o-Chinondiazide. Photoempfindliche o-Chinondiazide sind wohlbekannt. Beispiele dafür sind u.a. o-Benzochinondiazidsulfonylester oder -amide oder o-Naphthochinondiazidsulfonylester oder -amide von Verbindungen, insbesondere aromatischen Verbindungen, mit einer Hydroxylgruppe oder Aminogruppe. Bevorzugt werden o-Benzochinondiazidsulfonylester und o-Naphthochinondiazidsulfonylester von Phenolen, wie einwertigen Phenolen, und insbesondere mehrwertigen Phenolen, wie z.B. von 2,2-Bis(hydroxyphenyl)propanen, Dihydroxybiphenylen, di- und tri-hydroxysubstituierten Benzophenonen und von Phenolharzen, wie z.B. Phenolaldehydharzen, sowie Polymeren von Phenolen mit polymerisierbaren ungesättigten Substituenten. Geeignete Phenolaldehydharze, von welchen die Ester abgeleitet werden können, umfassen Novolakharze hergestellt ausgehend vom Phenol selbst, von einem alkylsubstituierten Phenol, wie z.B. o-, m- oder p-Kresol, o-, m- oder p-tert. Butylphenol, o-, m- oder p-Octylphenol oder von einem Bisphenol, wie z.B. 2,2-Bis(4-hydroxyphenyl)propan, oder einem Gemisch aus zwei oder mehreren solcher Phenole und einem Aldehyd, wie Acetaldehyd, Benzaldehyd, Glyoxylsäure oder vorzugsweise Formaldehyd. Geeignete Polymere ungesättigter Phenole, von denen die Ester abgeleitet werden können, umfassen Homo- und Copolymere von p-Vinylphenol und von p-Isopropenylphenol.

Bevorzugte o-Chinondiazidsulfonylester von Phenolen sind o-Naphthochinondiazidsulfonylester von Polyhydroxybenzophenonen oder von Novolakharzen, abgeleitet von Formaldehyd und einem alkylsubstituierten Phenol oder einem Gemisch eines alkylsubstituierten Phenols mit Phenol. Besonders bevorzugte Ester sind die 1,2-Naphthochinon-2-diazid-5-sulfonylsäureester von Dihydroxybenzophenonen, Trihydroxybenzophenonen oder von Novolaken hergestellt aus Formaldehyd und entweder einem Gemisch von o-, m- und p-Kresolen oder einem Gemisch von Phenol und p-tert-Butylphenol.

Die oben beschriebenen photoempfindlichen Chinondiazide sind entweder im Handel erhältich oder können mit üblichen Methoden, z.B. durch Umsetzung eines Phenols mit einem esterbildenden Derivat einer o-Chinondiazidsulfonsäure, im allgemeinen dem Sulfonylchlorid, unter üblichen Bedingungen hergestellt werden.

Weitere bevorzugte photosolubilisierbare Stoffe, welches als Komponente (C) verwendet werden können, sind o-Nitrophenylacetale, hergestellt aus einem o-Nitrobenzaldehyd und einem zweiwertigen Alkohol, Polyester solcher Acetale, hergestellt durch Umsetzung der Acetale mit einer Polycarbonsäure, oder einem reaktiven Derivat einer Polycarbonsäure, wie z.B. einem Anhydrid, und endverkappte mit einer Carbonsäure oder einem reaktiven Derivat einer Carbonsäure. Bevorzugt sind Acetale, welche vom o-Nitrobenzaldehyd und einem linearen Alkylenglykol, in dem die Alkylengruppe 4 bis 15 Kohlenstoffatome hat, die durch mindestens ein Sauerstoffatom unterbrochen werden können, oder einem Glykol, der einen 4 bis 7 kohlenstoffatomhaltigen cycloaliphatischen Ring enthält, wie z.B. Cycloalkylenglykol oder Cycloalkylenalkylglykol abgeleitet sind, sowie Polyester und enverkappte Derivate solcher Acetale.

Bevorzugte lineare Glykole, von denen die Acetale abgeleitet werden können, sind 1,4-Butandiol, 1,5-Pentandiol, 1,6-Hexandiol, 1,7-Heptandiol, Diethylen-, Dipropylen-, Triethylen- und Tripropylenglykol. Bevorzugte Glykole mit einem cycloaliphatischen Ring sind 2,2,4,4-Tetramethyl-1,3-cyclobutandiol, Bis(4-hydroxycyclohexyl)methan, 1,4-Cyclohexandiol, 1,2-Bis(hydroxymethyl)cyclohexan und insbesondere 1,4-Bis(hydroxymethyl)cyclohexan.

Bevorzugte Polyesteracetale sind solche, die durch Umsetzung der oben beschriebenen bevorzugten Acetale mit einer aromatischen Dicarbon- oder Tricarbonsäure oder deren Anhydriden, wie z.B. Phthalsäure, Terephthalsäure und Trimellitsäure und deren Anhydride, und Gemische von zwei oder mehreren dieser Säuren oder Anhydride, erhalten werden. Ein besonders bevorzugter Polyesteracetal wird durch Umsetzung eines

von o-Nitrobenzaldehyd und 1,4-Bis-(hydroxymethyl)-cyclohexan abgeleiteten Acetals mit Trimellitsäureanhydrid erhalten. Bevorzugte endverkappte Polyacetale werden durch Umsetzung der bevorzugten oben beschriebenen Acetale mit einer Monocarbonsäure oder eine reaktiven Derivat einer Monocarbonsäure erhalten, wie z.B. mit Essig- und Benzoesäure und deren Chloriden.

Weitere bevorzugte photosolubilisierbaren Stoffe, die als Komponente (C) verwendete werden können, sind Harze, insbesondere Epoxidharze, Polyurethane und Polyester, die in der Kette Benzoingruppen enthalten, wie z.B. die in der US Patentschrift 4,368,253 beschriebenen Stoffe. Unter den benzoingruppenhaltigen Harzen werden solche bevorzugt, in denen die Hydroxylgruppen am Nachbarkohlenstoffatom zur Carbonylgruppe verethert ist, d.h. solche mit Benzoinalkylethergruppen, worin die Alkylgruppen 1 bis 4 Kohlenstoffatome aufweisen. Besonders bevorzugt sind Epoxidharze, hergestellt durch Umsetzung eines Dihydroxybenzolinalkylethers mit einer Diglycidylverbindung, insbesondere mit einem Diglycidylether eines zweiwertigen Akohols oder Phenols oder einem Diglycidylhydantoin. Benzoingruppenhaltige Epoxidhärze können im erfindungsgemässen Verfahren als doppelfunktionelle Stoffe verwendet werden, wobei die Epoxidgruppen die kationische Polymerisierung in Stufe (ii) und die Benzoingruppen die Photosolubilisierung in Stufe (iii) bewerkstelligen.

Weitere bevorzugte photosolubilisierbare Stoffe, die als (C) verwendet werden können, sind Sulfonylester aromatischer Alkohole mit einer Carbonylgruppe in α- oder β-Stellung zur Sulfonatestergruppe und aromatische N-Sulfonyloxyimide. Bevorzugte derartige Ester und Imide sind die in der U.S. 4,618,564 beschriebenen Verbindungen, insbesondere Ester des Benzoins oder α-Methylolbenzoins, vorzugsweise Benzoin-p-toluolsulfonat und 3-(p-Toluolsulfonyloxy)-2-hydroxy-2-phenyl-1-phenyl-1-propanon und N-Sulfonyloxyderivate von 1,8-Naphthalimid, insbesondere N-Benzolsulfonyloxy- und N-(p-Dodecylbenzolsulfonyloxy)-1,8-naphthalimid. Weitere bevorzugte derartige Ester und Imide sind organische Polymere mit photoempfindlichen Resten enthaltend entweder (a) eine Sulfonylgruppe, welche über das Oxysauerstoffatom in der α-oder β-Stellung zur Carbonylgruppe und in α- oder β-Stellung zu einer aromatischen Gruppe an ein aliphatisches Kohlenstoffatom gebunden ist, oder (b) eine über die Carbonylgruppen oder das Schwefelatom direkt an eine aromatische Gruppe gebundene N-Sulfonyloxyimidgruppe. Solche geeigneten Polymere sind z.B. Verbindungen enthaltend mindestens einen Rest der Formel XIII

$$(-L^1)_{m'} Ar^1[Z^1]-OSO_2-Ar^2(-L^2-)_{n^1} \quad (XIII),$$

worin eines der Symbole m' oder $n^1$ 1 und das andere Null oder 1 bedeuten, Z für entweder eine Gruppe der Formel XIV

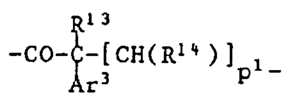 (XIV),

welche über die Carbonylgruppe an ein aromatisches Kohlenstoffatom in $Ar^1$ gebunden ist, oder für eine Gruppe der Formel XV

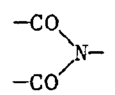 (XV),

welche über die Carbonylgruppen an aromatische Kohlenstoffatome von $Ar^1$ gebunden ist, $p^1$ Null oder 1 bedeutet, wobei, falls $p^1$ Null bedeutet, $R^{13}$ ein Wasserstoffatom oder eine einwertige aliphatische, araliphatische oder aromatische Gruppe bedeutet und falls $p^1$ 1 ist, $R^{13}$ ein Wasserstoffatom, eine Hydroxylgruppe, eine veretherte Hydroxylgruppe, eine Acyloxygruppe, eine Alkylgruppe oder eine phenylsubstituierte Alkylgruppe ist, $R^{14}$ ein Wasserstoffatom oder eine einwertige aliphatische, cycloaliphatische, heterocyclische, aromatische oder araliphatische Gruppe ist, $Ar^1$ eine einwertige, zweiwertige oder dreiwertige aromatische Gruppe, $Ar^2$ eine einwertige oder zweiwertige aromatische Gruppe, $Ar^3$ eine einwertige aromatische Gruppe, und $L^1$ und $L^2$ jeweils -CO-, -COO-, -CONH-, -OCOO-, -NHCONH-, -OCONH-, -CSS-, -OCSS-, $-OSO_2-$, $-CH_2-$, -CH=, -O-, -S- oder -N= bedeuten.

Bevorzugte solche Polymere sind phenolische Novolakharze, in welchen mindestens 4 % der phenolischen Hydroxylgruppen durch einen einwertigen Rest der Formel XIII, worin eines der Symbole m' und $n^1$ für 1 und das andere für Null stehen, und $Z^1$ ist entweder eine Gruppe der Formel XIV mit $Ar^1$ und $Ar^2$ jeweils gleich eine Phenyl-oder Phenylengruppe, wobei mindestens eine der Gruppen $Ar^1$ und $Ar^2$ Phenylen bedeutet, $Ar^3$ Phenyl, $R^{13}$ -H, -OH, $C_1$-$C_4$-Alkyl oder -Alkoxy und $R^{14}$, falls vorhanden, -H oder $C_1$-$C_4$-Alkyl bedeuten; oder

$Z^1$ ist eine Gruppe der Formel XV, worin $Ar^1$ für o-Phenylen, 1,8-Naphthylen oder eine Benzol-1,2,3-triylgruppe und $Ar^2$ für Phenyl, p-Tolyl oder m-oder p-Phenylen steht.

Polymere enthaltend einen Rest der Formel XIII können durch Umsetzung eines hydroxylgruppenhaltigen Polymers, wie z.B. eines Novolakharzes mit einer Carbonsäure der Formel XVI

$$(HOOC)_{x^1}\text{-}Ar^1\text{-}Z^1\text{-}OSO_2\text{-}Ar^2\text{-}(COOH)_{y^1} \qquad (XVI)$$

oder einem esterbildenden Derivat dieser Säure hergestellt werden, wobei eines der Symbole $x^1$ und $y^1$ 1 und das andere Null oder 1 bedeutet, und $Z^1$, $Ar^1$ und $Ar^2$ die oben angegebene Bedeutung haben.

Ein besonders bevorzugtes Polymer wird durch Umsetzung eines phenolischen Novolaks mit dem Säurechlorid von N-(4-Carboxyphenylsulfonyloxy)-1,8-naphthalimid erhalten, wobei die letztgenannte Verbindung durch Umsetzung von N-Hydroxy-1,8-naphthalimid mit 4-Chlorsulfonylbenzoesäure erhalten wird.

Weitere bevorzugte photosolubilisierbare Stoffe, welche sich für die Verwendung als (C) eignen, sind aromatische Oximsulfonate, vorzugsweise die in der EP-A 199,672 beschriebenen Verbindungen, oder nichtreaktive Derivate der in der erwähnten EP-A beschriebenen reaktiven Oximsulfonate. Besonders bevorzugte Oximsulfonate sind Verbindungen der Formel XVII

$$R^{15}\text{-}C(R^{16})\text{=N-O-}SO_2\text{-}R^{17} \qquad (XVII),$$

worin einer der Reste $R^{15}$ und $R^{16}$ eine einwertige aromatische Gruppe, insbesondere Phenyl oder 4-Methoxyphenyl, und der andere Cyano ist, oder $R^{15}$ und $R^{16}$ bilden zusammen mit dem Kohlenstoffatom an das sie gebunden sind, eine carbocyclische oder heterocyclische Gruppe, insbesondere ein Fluoren- oder Anthron-Ringsystem, und $R^{17}$ eine aliphatische, carbocyclische, heterocyclische oder araliphatische Gruppe ist, insbesondere 4-Tolyl, 4-Chlorphenyl oder 4-Dodecylphenyl.

Die Oximsulfonate können, wie in der EP-A 199,672 beschrieben, hergestellt werden. Die besonders bevorzugten Stoffe können durch Umsetzung eines Oxims der Formel $R^{15}$-C($R^{16}$)=N-OH mit einem Sulfonylchlorid der Formel $R^{17}SO_2Cl$, im allgemeinen in einem inerten organische Lösungsmittel in Gegenwart eines tertiären Amins, hergestellt werden.

Wie bereits erwähnt, können der polymerisierbare Rest (A) und der photosolubilisierbare Rest (C) im gleichen Molekül einer doppelfunktionellen Verbindung sein. Geeignete doppelfunktionelle Verbindungen sind z.B. Stoffe, welche eine Acrylgruppe und eine o-Chinondiazidsulfonylestergruppe enthalten, wie z.B. ein o-Chinondiazidsulfonylester eines amino- oder carboxylsubstituierten Phenols, in dem die Amino- oder die Carboxylgruppe mit einem eine Acrylgruppe enthaltenden Rest acyliert oder esterifiziert ist. Geeignete Ester sind z.B. o-Chinondiazidsulphonester von Reaktionsprodukten amino-substituierter Phenole mit Acryloylchlorid oder Methacryloylchlorid oder Reaktionsprodukte carboxysubstituierter Phenole, oder deren Säurehalogenide mit einem Hydroxyalkylacrylat oder Methacrylat. Bevorzugte derartige Ester sind o-Chinondiazidsulfonylester von Acryloylamino- oder Methacryloylamino-substituierten Phenolen, wie z.B. 4-(o-Naphthochinondiazidsulfonyloxy-)methacryloylanilid.

Eine weitere bevorzugte Klasse von photosolubilisierbaren Chinondiaziden, welche als (C) verwendet werden können, sind Polymere doppelfunktioneller Verbindungen, die sowohl eine Acrylgruppe als auch eine Chinondiazidsulfonylestergruppe enthalten. Diese Polymere können Homopolymere oder Copolymere mit einem oder mehreren polymerisierbaren ethylenisch ungesättigten Stoffen, vorzugsweise acrylischen Monomeren, wie z.B. Acryl- und Methacrylsäuren und Alkyl- und Hydroxyalkylacrylaten und -methacrylaten, sein. Unter diesen Polymeren werden Copolymere von o-Chinondiazidsulfonylestern der oben beschriebenen Acryloylamino- oder Methacryloylamino-substituierten Phenole mit Acrylsäure oder Methacrylsäure und Methylmethacrylat oder 2-Hydroxyethylmethacrylat, bevorzugt.

Falls das photosolubilisierbare Material ein oben beschriebener Sulfonatester eines aromatischen Alkohols, ein N-Sulfonyloxyderivat, ein Oximsulfonat oder ein Chinondiazid ist, und falls der Stoff selbst nicht ein filmbildendes Polymer ist, wird ein in wässriger Base lösliches filmbildendes Polymer dem flüssigen Stoffgemisch beigefügt, wenn ein solches Polymer nicht durch Polymerisierung in Stufe (ii) gebildet wird.

Vorzugsweise wird ein in wässriger Base lösliches filmbildendes Polymer dem flüssigen Stoffgemischen auch dann beigegeben, wenn ein Polymer in Stufe (ii) gebildet wird.

Geeignete, in wässriger Base lösliche, filmbildende Polymere sind solche, welche phenolische Hydroxylgruppen oder Carbonsäure- oder Sulfonsäuregruppen enthalten. Beispiele solcher Polymere sind Carboxylendständige Polyester, Homopolymere und Copolymere ethylenisch ungesättigter Phenole und Homopolymere und Copolymere der Vinylsulfonsäure. Bevorzugte in wässriger Base lösliche filmbildende Polymere sind Novolakharze, abgeleitet von einem Aldehyd, wie z.B. Acetaldehyd, Furfuraldehyd oder Benzaldehyd, vorzugsweise Formaldehyd, und einem Phenol, wie Phenol selbst, einem mit 1 oder 2 Chloratomen substituierten Phenol, wie z.B. p-Chlorphenol, einem mit einer oder zwei Alkylgruppen mit 1 bis 9 Kohlenstoffatomen pro Alkylgruppe substituierten Phenol wie z.B. o-, m- und p-Kresol, Xylenole, p-tert. Butylphenol und p-Nonylphenol, p-Phenylphenol, Resorcin, Bis(4-hydroxyphenyl)methan, 2,2-Bis(4-hydroxyphenyl)propan oder von Gemischen solcher Phenole. Weitere bevorzugte filmbildende Stoffe sind Homo- und Copolymere ethylenisch ungesättigter Carbonsäuren und Carbonsäureanhydride. Solche Polymere umfassen Homopolymere der Acrylsäure, Methacrylsäure und des Maleinanhydrids und Copolymere dieser Monomere mit einem oder mehreren anderen ethylenisch ungesättigten Stoffen, z.B. aliphatisch ungesättigten Verbindungen wie Ethylen, Propylen, Estern der Acrylsäure und Methacrylsäure, Vinylestern, Vinylacetat, und vinylaromatischen Verbindungen, wie Styrol und substituierte Styrole.

Das Gewichtsverhältnis des kationisch polymerisierbaren oder des durch Einwirkung freier Radikale polymerisierbaren Materials (A) zum photosolubilisierbaren Rest (C) ist nicht kritisch, solange wirksame Mengen beider Komponenten verwendet werden.

Wenn (A) und (C) in verschiedenen Molekülen sind, ist das Gewichtsverhältnis (A) : (C) im allgemeinen von 10:1 bis 1:10, vorzugsweise von 5:1 bis 1:2. Die Menge des Polymerisationsinitiators (B) der verwendet wird, ist auch nicht kritisch, solange sie ausreicht, um die Polymerisation von (A) während der ersten Belichtung mit aktinischer Strahlung einzuleiten. Typischerweise werden 0,1 - 50 Gewichtsteile (B), vorzugsweise 0,5 - 10 Gewichtsteile (B), pro 100 Gewichtsteile (A) eingesetzt.

Die erfindungsgemäss verwendeten flüssigen Stoffgemische können auch weitere bekannte, in der Technik der Bilderzeugung verwendete Zusätze enthalten. Beispiele solcher Zusätze sind Pigmente, Farbstoffe, Füllstoffe und verstärkende Füllstoffe, Flammschutzmittel, antistatische Wirkstoffe, Egalisiermittel, Antioxidantien, Lichtschutzmittel und Netzmittel.

Die flüssigen Stoffgemische können auch hydrophile Polymere enthalten, um die Erzeugung von in Wasser entwickelbaren Bildern zu erleichtern. Geeignete hydrophile Polymere umfasssen Polyalkylenglykole, wie z.B. Polyethylenglykol, Polyacrylamide, Polyvinylpyrrolidone und vorzugsweise Polyvinylalkohole (hydrolysierte Polyvinylacetate). Wenn hydrophile Polymere verwendet werden, werden sie im allgemeinen in einer Menge von 0,5 bis 20 Gew.% des Stoffgemisches eingesetzt.

Als Lichtquellen eignen sich z.B. Kohlebögen, Metallhalogenidlampen, Quecksilberdampflampen, fluoreszierende Lampen mit ultraviolettem Licht emittierenden Phosphoren, Argon- und Xenonglühlampen, Wolframlampen und photographische Flutlichtlampen. Es ist wichtig, dass die erste Belichtung bei verschiedener Wellenlänge erfolgt als die zweite. Es kann von Vorteil sein, Filter zu verwenden, um Strahlung unerwünschter Wellenlänge auszuschliessen, so dass auf diese Art für beide Belichtungen auch eine einzelne Lichtquelle breiten Spektrums verwendet werden kann. Wenn eine derartige einzelne Lichtquelle verwendet wird, wird die erste Belichtung durch einen Filter durchgeführt, der Strahlen der Wellenlänge, welche den Rest (C) aktiviert, daran hindert, das Stoffgemisch zu erreichen. Bei der zweiten Belichtung kann das ganze unfiltrierte Spektrum der Lichtquelle verwendet werden, so dass die Strahlung, welche die Solubilisierung des Restes (C) verursacht, das Stoffgemisch erreichen kann.

Für den Fachmann auf dem Gebiet der Bilderzeugung ist es selbstverständlich, dass diese Lichtquellen auch kleine Mengen von Strahlen unterschiedlicher Wellenlänge emittieren, aber den grössten Teil der Strahlung bei einer bestimmtten Wellenlänge, der Wellenlänge des Intensitätsmaximums, emittieren. Wenn in der vorliegenden Anmeldung von der Verwendung von Strahlen verschiedener Wellenlänge die Rede ist, versteht man darunter, dass die Wellenlängen der Intensitätsmaxima der in den Stufen (ii) und (iii) verwendeten Strahlung verschieden sein müssen. Eine Ueberlappung der Spektralbereiche, in denen die in den Stufen (ii) und (iii) verwendeten Lichtquellen kleine Mengen an Strahlung emittieren, wird im allgemeinen nicht die erfolgreiche Durchführung des erfindungsgemässen Verfahrens beeinträchtigen.

Die erste Belichtung [Stufe (ii)] muss nur lang genug sein, um den Polymerisationsinitiator (B) zu aktivieren. Im allgemeinen genügen einige Minuten. Die tatsächlich benötigte Zeit kann auf einfache Weise experimentell ermittelt werden. Der aktivierte Initiator (B), gegebenenfalls in Gegenwart eines organischen Peroxids oder Hydroperoxids, verursacht die Polymerisation des Restes (A). In manchen Fällen, bei Verwendung von Verbindungen der Formel X als Initiator (B), muss das Gemisch unter Umständen auch etwas erhitzt werden, um die Polymerisation zu erleichtern. Um den Rest (A) zu polymerisieren, kann das Stoffgemisch z.B. auf eine Temperatur von 80 bis 120°C erhitzt werden. Ein längeres Erhitzen als die für die Polymerisation des Restes (A) benötigte Zeit ist nicht erforderlich. Meistens genügen einige wenige Minuten. Die tatsächlich erforderliche Temperatur und Zeit können durch einfache Experimente ermittelt werden.

Die beschriebenen Zusammensetzungen können als Flüssigkeiten auf Substrate, wie z.B. Strahl, Aluminium, Kupfer, Papier, Silicium oder Kunststoffe, appliziert werden. Nach dem Auftragen der Schicht findet die erste Belichtung statt, falls nötig gefolgt von Erhitzen, um das Gemisch zu verfestigen. Das beschichtete Substrat ist dann stabil und kann längere Zeit gelagert werden, falls es nicht Strahlung, welche (C) solubilisiert, ausgesetzt ist. Im gewünschten Zeitpunkt wird das beschichtete Substrat bildmässig mit aktinischer Strahlung einer verschiedenen Wellenlänge von der in der ersten Stufe verwendeten belichtet. Die Bereiche der Schicht, welche das zweite Mal belichtet wurden, können dann durch Waschen in einem geeigneten Lösungsmittel, oder vorzugsweise mit einer wässrigen Base, wie z.B. verdünntes wässriges Natriumcarbonat oder Natriumhydroxid, entfernt werden.

Bereiche der Schicht, welche nicht das zweite Mal belichtet wurden, verbleiben am Substrat und bilden ein Positivbild. Somit kann das erfindungsgemässe Verfahren für die Herstellung von Druckplatten und gedruckten Schaltungen unter Einsatz bekannter Techniken verwendet werden.

Die folgenden Beispiele erläutern die Erfindung näher. Die verwendeten Teile sind ohne andere Angaben Gewichtsteile. Die in den Ausführungsbeispielen verwendeten polymerisierbaren und photosolubilisierbaren, mit Harz I bis VI bezeichneten, Stoffe sind:

Harz I: Ein Harz mit einem Molekulargewicht von 1450, hergestellt durch Umsetzung eines Novolaks, der aus 3 Mol Phenol und 1 Mol p-tert-Butylphenol mit Formaldehyd synthetisiert wurde, mit 1,2-Naphthochinon-2-diazid-5-sulfonylchlorid, so dass 12 % der phenolischen Hydroxylgruppen verestert sind.

Harz II: Ein Ester hergestellt aus 1 Mol 2,3,4-Trihydroxybenzophenon mit 2,5 Mol 1,2-Naphthochinon-2-diazid-5-sulfonylchlorid.

Harz III: Ein Gemisch aus n-Butanol (14,5 g) und pulverförmigem Natriumhydroxid (8 g) wird unter Stickstoff bei 70°C während einer Stunde erhitzt. Im Zeitraum von 1 1/2 wird 2-Chlorethylvinylether (21,3 g) beigegeben, und das Gemisch wird bei 70 - 80°C weitere 5 Stunden gerührt. Das resultierende Gemisch wird abgekühlt und filtriert. Man erhält 21 g 2-Butoxyethylvinylether als braune Flüssigkeit. IR (Film) 2965, 2940, 2880, 1621, 1328, 1211, 1080, 968, 828 $cm^{-1}$; NMR (DMSO-$d_6$), 0,5 - 1,2 (m, 7H), 3,3 - 4,4 (m, 8H), 6,5 (q, 1H)$\delta$.

Harz IV: Ein Gemisch aus o-Nitrobenzaldehyd (100,6 g), 1,4-Bis(hydroxymethyl)cyclohexan (192 g), p-Toluolsulfonsäure (0,2 g) und Dichlormethan (600 g) wird während 4 1/2 Stunden unter Rückflüss und gleichzeitiger azeotroper Entfernung von Wasser mittels einer Dean und Stark Apparatur erhitzt, und dann bis zur Temperatur von 140°C destilliert, gefolgt von Rühren währen 16 Stunden bei 140°C. Das resultierende Gemisch wird bei 140°C und reduziertem Druck destilliert und mit Xylol (140 g) bis zu einem Feststoffgehalt von 66 % verdünnt. Ein Teil dieser Lösung (40 g) wird mit Trimellitanhydrid (12 g) bei 150°C während 4 Stunden erhitzt. Das Gemisch wird dann bei 150°C und reduziertem Druck destilliert, wobei 33 g des erwünschten Polyesteracetals als Produkt erhalten werden.

Harz V: Ein Gemisch aus p-Aminophenol (20 g), p-Methoxyphenol (0,2 g), Aceton (200 ml) und Pyridin (15 g) wird auf unter 0°C gekühlt, Methacryloylchlorid (21 g) wird zugetropft und die Temperatur wird dabei auf unter 0°C gehalten. Dann wird das Gemisch 2 Stunden bei 0°C und 2 Stunden bei Raumtemperatur gerührt. Das erhaltene Reaktionsgemisch wird zu einem Drittel des ursprünglichen Volumens konzentriert und dann in verdünnte Chlorwasserstoffsäure (500 ml, pH=1) gegossen. Der Niederschlag wird abfiltriert, in Methanol gelöst und wieder in verdünnter Chlorwasserstoffsäure (500 ml, pH=1) ausgefällt. Nach Umkristallisierung aus wässrigem Ethanol werden 8 g p-Hydroxymethacryloylanilid erhalten.

Chlorsulfonsäure (67,8 g) wird bei Raumtemperatur zu o-Naphthochinon-diazid-5-sulfonsäure-Natriumsalz (13,6 g) zugetropft. Das Gemisch wird eine Stunde bei 50°C erhitzt und langsam über 500 g zerkleinertes Eis gegossen. Der erhaltene Niederschlag wird isoliert und in Dioxan (40 ml) gelöst. Diese Lösung wird langsam einem Gemisch aus p-Hydroxymethacryloylanilid (8 g), Triethylamin (4,9 g) und Dioxan (60 ml) beigegeben und die Temperatur wird dabei auf unter 10°C gehalten. Nach Beendigung der Zugabe wird noch weitere 2 Stunden bei unter 10°C gerührt. Dem Gemisch werden dann Wasser (1000 g) enthaltend 5,9 g konzentrierter Chlorwasserstoffsäure zugegeben. Der erhaltene Niederschlag wird abfiltriert und getrocknet um 10,4 g des gewünschten Produkts, 4-(o-Naphtochinondiazidsulfonyloxy)-methacryloylanilid zu erhalten.

Harz VI: Ein Gemisch auf Methylmethacrylat (9 g), Methacrylsäure (5 g), Harz V (6 g), Azobis(isobutyronitril) (0,2 g) und Tetrahydrofuran (60 g) wird während 6 Stunden unter Stickstoff bei 60°C erhitzt. Das Gemisch wird dann in Hexan (300 ml) gegossen und der resultierende Niederschlag wird isoliert und getrocknet, um 7,8 g des gewünschten polymeren Produkts zu erhalten.

In den nachfolgenden Beispielen werden die folgenden Strahlungsquellen verwendet:

1) 500 W Wolframlampe, welche oberhalb von 450 nm strahlt, da Strahlen kürzerer Wellenlänge mit einem Filter entfernt werden.

2) 5 kW Metallhalogenidlampe, mit einem Bereich von 340 - 450 nm und einem Intensitätsmaximum bei 435 nm.

3) Mitteldruck Quecksilberdampflampe mit einem Bereich von 200 - 400 nm und einem Intensitätsmaximum bei 365 nm

Beispiel 1: Drei Teile Harz I, 7 Teile 2-Hydroxyethylmethacrylat und 0,2 Teile Bis($\pi$-methylcylopentadienyl)bis($\sigma$-hexanoxytetrafluorphenyl)titan (IV) werden zu einem homogenen Gemisch vermischt. Das Gemisch wird auf ein kupferbeschichtetes Laminat zu einer Schicht von 36 $\mu$m aufgetragen. Das beschichtete Laminat wird dann unter Stickstoff mit einer 500 Wolframhalogenlampe, welche mit einem Filter versehen ist, um Strahlung von unter 450 nm zu entfernen, aus einer Entfernung von 20 cm während 10 Minuten

belichtet. Der verfestigte Ueberzug wird durch ein Dia mit einer 5 kW Metallhalogenidlampe aus einer Entfernung von 75 cm während 2 Minuten belichtet. Nach Entwicklung in 0,5 %igem wässrigem Natriumhydroxid unter leichtem Reiben erhält man ein Positivbild des Dias.

Beispiel 2: 5 Teile Harz I, 5 Teile Neopentylglykoldiacrylat, 2,5-Teile 1,4-Butandiol und 0,2 Teile Bis(π-methylcylcopentadienyl)-bis(σ-hexanoxytetrafluorphenyl)titan (IV) werden zu einem homogenen Gemisch vermischt. Das Gemisch wird auf eine kupferbeschichtetes Lamint zu einer Schicht von 36 μm aufgetragen. Das beschichtete Laminat wird dann unter Stickstoff mit der im Beispiel 1 beschriebenen 500 W Wolframhalogenlampe während 5 Minuten belichtet. Die verfestigte Schicht wird durch ein Dia mit einer 5 kW Metallhalogenidlampe aus einer Entfernung von 75 cm während 2 Minuten belichtet. Die Entwicklung in 0,5 %igem wässrigem Natriumhydroxid unter leichtem Reiben ergibt ein Positivbild des Dias.

Beispiel 3: 5 Teile Harz I, 5 Teile α-Pinenoxid, 2,5 Teile 1,4-Butandiol, 0,35 Teile (π-2,4-Cyclopentadien-1-yl) [(1,2,3,4,5,6-π)-(1-methylethyl)benzol]eisen-II-hexafluorphosphat und 0,35 Teile Cumolhydroperoxid werden zu einem homogenen Gemisch vermischt. Das Gemisch wird auf ein kupferbeschichtetes Laminat zu einer Schicht von 36 μm aufgetragen. Das beschichtete Laminat wird dann mit der im Beispiel 1 beschriebenen 500 W Wolframhalogenidlampe während 5 Minuten belichtet. Die verfestigte Schicht wird mit einer 5 kW Metallhalogenidlampe aus einer Entfernung von 75 cm während 2 Minuten durch ein Dia belichtet. Entwicklung in 0,5 %igem wässrigem Natriumhydroxid unter leichtem Reiben ergibt ein Positivbild des Dias.

Beispiel 4: 3 Teile Hatz I, 7 Teile 2-Hydroxyethylmethacrylat und 0,5 Teile DL-Campherchinon werden zu einem homogenen Gemisch vermischt. Das Gemisch wird auf ein kupferbeschichtetes Laminat zu einer Schicht von 36 μm aufgetragen. Das beschichtete Laminat wird dann unter Stickstoff mit der im Beispiel 1 beschriebenen 500 W Wolframhalogenlampe während 10 Minuten belichtet. Die verfestigte Schicht wird aus einer Entfernung von 75 cm während 2 Minuten mit einer 5 kW Metallhalogenidlampe durch ein Dia belichtet. Entwicklung in 1,5 %igem wässrigem Natriumhydroxid unter leichtem Reiben ergibt ein Positivbild des Dias.

Beispiel 5: 6 Teile Harz I, 2 Teile 2-Hydroxyethylmethacrylat, 2 Teile Acrylsäure und 0,15 Teile Bis(π-methylcyclopentadienyl)-bis(σ-hexanoxytetrafluorphenyl)titan (IV) werden vermischt. Das Gemisch wird auf ein kupferbeschichtetes Laminat zu einer Schicht von 36 μm aufgetragen. Das beschichtete Laminat wird dann mit der im Beispiel 1 beschriebenen 500 W Wolframhalogenlampe während 5 Minuten belichtet. Die verfestigte Schicht wird durch ein Dia aus einer Entfernung von 75 cm während 2 Minuten mit einer 5 kW Metallhalogenidlampe belichtet. Entwicklung in 0,5%igem wässrigem Natriumhydroxid ergibt ein Positivbild des Dias.

Beispiel 6: 5 Teile Harz I, 7 Teile α-Pinenoxid, 0,35 Teile Diphenyliodoniumhexafluorphosphat und 0,05 Teile Acridinorange werden vermischt. Das Gemisch wird auf ein kupferbeschichtetes Laminat zu einer Schicht von 36 μm aufgetragen. Das beschichtete Laminat wird dan mit der im Beispiel 1 beschriebenen Wolframhalogenlampe während 5 Minuten belichtet. Der verfestigte Ueberzug wird durch ein Dia mit einer 5 kW Metallhalogenidlampe aus einer Entfernung von 75 cm während 2 Minuten belichtet. Entwicklung in 0,5 %igem wässrigem Natriumhydroxid mit leichtem Reiben ergibt ein Positivbild des Dias.

Beispiel 7: 5 Teile Harz I, 3,5 Teile Diallylbisphenol A, 3,5 Teile Ethylenglykolbisthioglykolat und 0,2 Teile Bis(π-methylcyclopentadienyl)bis(σ-hexanoxytetrafluorphenyl)titan (IV) werden vermischt. Das Gemisch wird auf ein kupferbeschichtetes Laminat zu einer Schicht von 36 μm aufgetragen. Das beschichtete Laminat wird dann unter Stickstoff mit der im Beispiel 1 beschriebenen 500 W Wolframhalogenlampe während 10 Minuten belichtet. Der verfestigte Ueberzug wird durch ein Dia aus einer Entfernung von 75 cm während 2 Minuten mit einer 5 kW Metallhalogenidlampe belichtet. Entwicklung in 0,5 %igem wässrigem Natriumhydroxid unter leichtem Reiben ergibt ein Positivbild des Dias.

Beispiel 8: 4 Teile Harz I, 5 Teile α-Pinenoxid, 2 Teile 1,4-Butandiol und 0,35 Teile (π-2,4-Cyclpentadien-1-yl)[(1,2,3,4,5,6-π)-(1-methylethyl)benzol]eisen-II-hexafluorphosphat werden zu einem homogenen Gemisch vermischt. Das Gemisch wird auf ein kupferbeschichtetes Laminat zu einer Schicht von 12 μm aufgetragen. Das beschichtete Laminat wird dann mit der im Beispiel 1 beschriebenen 500 W Wolframhalogenlampe während 10 Minuten belichtet. Der verfestigte Ueberzug wird durch ein Dia aus einer Entfernung von 75 cm während 2 Minuten mit einer 5 kW Metallhalogenidlampe belichtet. Entwicklung in 1 %igem wässrigem Natriumhydroxid unter leichtem Reiben ergibt ein Positivbild des Dias.

Beispiel 9: 5 Teile Harz II, 6 Teile 2-Hydroxethylmethacrylat und 0,2 Teile Bis(π-methylcyclopentadienyl)bis(σ-hexanoxytetrafluorphenyl)titan (IV) werden zu einem homogenen Gemisch vermischt. Das Gemisch wird auf ein kupferbeschichtetes Laminat zu einer Schicht von 12 μm aufgetragen. Das beschichtete Laminat wir dann mit der im Beispiel 1 beschriebenen 500 W Wolframhalogenlampe während 5 Minuten belichtet. Der verfestigte Ueberzug wird durch ein Dia aus einer Entfernung von 75 cm während 3 Minuten mit einer 5 kW Metallhalogenidlampe belichtet. Entwicklung in 0,5 %igem wässrigem Natriumhydroxid unter leichtem Reiben ergibt ein Positivbild des Dias.

Beispiel 10: 3 Teile Harz I, 7 Teile Harz III und 0,35 Teile (π-2,4-Cyclopentadien-1-yl)[(1,2,3,4,5,6-π)(1-methylethyl)benzol])eisen-II-hexafluorphosphat werden zu einem homogenen Gemisch vermischt. Das Gemisch wird auf ein kupferbeschichtetes Laminat zu einer Schicht von 36 μm aufgetragen. Das beschichtete Laminat wird dann mit der im Beispiel 1 beschriebenen 500 W Wolframhalogenlampe während 2 Minuten belichtet. Der verfestigte Ueberzug wird durch ein Dia aus einer Entfernung von 75 cm während 2 Minuten mit einer 5 kW Metallhalogenidlampe belichtet. Entwicklung in 0,5 %igem wässrigem Natriumhydroxid unter leichtem Reiben ergibt ein Positivbild des Dias.

Beispiel 11: 5 Teile Harz IV, 5 Teile 2-Hydroxethylmethacrylat und 0,2 Teile Bis(π-methylcyclopentadienyl)bis(σ-hexanoxyltetrafluorphenyl)titan (IV) werden zu einem homogenen Gemisch vermischt. Das Gemich wird auf ein kupferbeschichtetes Laminat zu einer Schicht von 36 μm aufgetragen. Das beschichtete Laminat wird dann unter Stickstoff mit der im Beispiel 1 beschriebenen 500 W Wolframhalogenlampe während 10 Minuten belichtet. Der verfestigte Ueberzeug wird durch ein Dia aus einer Entfernung von 75 cm während 4 Minuten mit einer 5 kW Metallhalogenidlampe belichtet. Entwicklung in 2 %igem wässrigem Natriumcarbonat unter leichtem Reiben ergibt ein Positivbild des Dias.

Beispiel 12: 5 Teile Harz I, 5 Teile 3,4-Epoxycyclohexylmethyl-3′,4′-epoxycyclohexancarboxylat, 2,5-Teile 1,4-Butandiol, 0,5 Teile Triphenylsulfoniumhexafluorantimonat und 0,5 Teile Propylencarbonat werden zu einem homogenen Gemisch vermischt. Das Gemisch wird auf ein kupferbeschichtetes Laminat zu einer Schicht von 24 μm aufgetragen. Das beschichtete Laminat wird dann mit einer Mitteldruck-Quecksilberdampflampe mit einem Intensitätsmaximum bei 365 nm aus einer Entfernung von 20 cm während 15 Sekunden belichtet, um die Schicht zu verfestigten. Der feste Ueberzeug wird durch ein Dia aus einer Entfernung von 75 cm während 3 Minuten mit einer 5 kW Metallhalogenidlampe mit einem Intentisätsmaximum bei 435 nm belichtet. Entwicklung in 0,5 %igem wässrigem Natriumhydroxid ergibt ein Positivbild des Dias.

Beispiel 13: 3 Teile Harz V, 7 Teile 2-Hydroxyethylmethacrylat und 0,2 Teile Bis(π-methylcyclopentadienyl)bis(σ-hexanoxytetrafluorphenyl)titan (IV) werden zu einem homogenen Gemisch vermischt. Das Gemisch wird auf ein kupferbeschichtetes Laminat zu einer Schicht von 12 μm aufgetragen. Das beschichtete Laminat wird dann unter Stickstoff mit der in Beispiel 1 beschriebenen 500 W Wolframhalogenlampe während 7 1/2 Minuten belichtet. Der verfestigte Ueberzug wird durch eine Dia aus einer Entfernung von 75 cm während 2 Minuten mit einer 5 kW Metallhalogenidlampe belichtet. Entwicklung in 0,5 %igem wässrigem Natriumhydroxid unter leichtem Reiben ergibt ein Positivbild des Dias.

Beispiel 14: 3 Teile Harz VI, 7 Teile 2-Hydroxyethylmethacrylat und 0,2 Teile Bis(π-methylcyclopentadienyl)bis(σ-hexanoxytetrafluorphenyl)titan (IV) werden zu einem homogenen Gemisch vermischt. Das Gemisch wird auf ein kupferbeschichtetes Laminat zur einer Schicht von 12 μm aufgetragen. Das beschichtete Laminat wird dann unter Stickstoff mit der im Beispiel 1 beschriebenen 500 W Wolframhalogenlampe während 5 Minuten belichtet. Der verfestigte Ueberzug wird durch ein Dia aus einer Entfernung von 75 cm während 2 Minuten mit einer 5 kW Metallhalogenidlampe belichtet. Entwicklung in 0,5 %igem wässrigem Natriumhydroxid unter leichtem Reiben ergibt ein Positivbild des Dias.

## Patentansprüche

1. Verfahren zur Bilderzeugung, worin
   (i) ein Substrat mit einer flüssigen Zusammensetzung enthaltend
      (A) einen kationisch oder durch Einwirkung freier Radikale polymerisierbaren Rest,
      (B) einen strahlungsaktivierbaren Polymerisationsinitiator für (A) und
      (C) einen strahlungssolubilisierbaren Rest beschichtet wird,
   (ii) die Zusammensetzung mit Strahlen einer Wellenlänge belichtet wird, bei der (B) aktiviert wird, aber (C) im wesentlichen nicht aktiviert wird, sie anschliessend gegebenenfalls erhitzt wird, wobei (A) polymerisiert und die flüssige Zusammensetzung sich verfestigt,
   (iii) die verfestigte Schicht in einem vorbestimmten Muster mit einer Strahlung verschiedener Wellenlänge als die in Stufe (ii) verwendete belichtet, wobei der Rest (C) aktiviert wird, so dass die verfestigte Schicht in den belichteten Bereichen der Oberfläche in einem Entwickler löslicher wird als in den unbelichteten Bereichen und
   (iv) die belichteten Bereiche der Schicht durch Einwirkung eines Entwicklers entfernt werden.

2. Verfahren nach Anspruch 1, worin die flüssige Zusammensetzung (B) einen strahlungsaktivierbaren Polymerisationsinitiator und entweder (1) ein Gemisch aus mindestens einer Verbindung mit einem polymerisierbaren Rest (A) und mindestens einer Verbindung mit einem strahlungssolubilisierbaren Rest (C), der durch Strahlung verschiedener Wellenlänge als (B) aktiviert wird, oder (2) mindestens eine doppelfunktionelle Verbindung, welche im gleiche Molekül sowohl einen polymerisierbaren Rest (A) als auch einen strahlungssolubilisierbaren Rest (C), der bei Strahlung verschiedener Wellenlänge als (B) aktiviert wird, enthält, oder (3) mindestens die oben erwähnte doppelfunktionelle Verbindung mit mindestens einer Verbindung mit einem polymerisierbaren Rest (A) und/oder mindestens einer Verbindung mit einem strahlungssolubilisierbaren Rest (C), enthält.

3. Verfahren nach den Ansprüchen 1 oder 2, worin (A) eine ethylenisch ungesättigte Gruppe oder ein Gemisch einer ethylenisch ungesättigten Gruppe und einer Thiolgruppe ist.

4. Verfahren nach Anspruch 3, worin (A) ein Ester enthaltend eine Gruppe der Formel I ist

$$CH_2=C(R^1)COO- \qquad (I),$$

worin $R^1$ für ein Wasserstoff-, Chlor- oder Bromatom oder eine Alkylgruppe mit 1 bis 4 Kohlenstoffatomen steht.

5. Verfahren nach Anspruch 4, worin (A) ein Monoacrylat oder ein Monomethacrylat ist.

6. Verfahren nach Anspruch 3, worin (A) ein Gemisch eines mit zwei oder mehreren Allylgruppen substituierten Phenols und eines Polythiols ist.

7. Verfahren nach einem der vorhergehenden Ansprüche, worin der Initiator (B) ein Benzoinether, ein Acyloinether, ein halogeniertes Alkyl- oder Arylderivat, ein aromatisches Carbonylderivat, ein Metallocen, ein Gemisch einer organometallischen Verbindung eines Metalls der Gruppe IVa mit einem photoreduzierbaren Farbstoff, ein Chinon, eine aliphatische Dicarbonylverbindung, ein 3-Ketocumarin, ein Acylphosphinoxid, ein Metallcarbonyl oder ein Gemisch eines photoreduzierbaren Farbstoffs mit einem Reduktionsmittel ist.

8. Verfahren nach den Ansprüchen 1 oder 2, worin (A) ein 1,2-Epoxid, ein Vinylether oder ein Gemisch dieser Verbindungen ist.

9. Verfahren nach Anspruch 8, worin der Initiator (B) eine Verbindung der Formel VII ist

$$[R^{10}]^{+an} \qquad \frac{an}{q}\,[LT_m]^{-q} \qquad (VII),$$

worin L ein zweiwertiges bis siebenwertiges Metall oder Nichtmetall ist, T ein Halogenatom bedeutet oder einer der Reste T auch eine Hydroxylgruppe sein kann, q eine ganze Zahl von 1 bis 3 ist, m eine ganze Zahl ist, die der Wertigkeit von L+q entspricht, a 1 oder 2 ist und n ganze Zahl von 1 bis 3 bedeutet und $R^{10}$ ein Ion ist, das ausgewählt wird aus der Gruppe bestehend aus

(i) aromatische Iodoniumionen;

(ii) $[G\text{-}Z\text{-}(CO)_x]^+$,

worin G ein Aren oder eine Dienyliumgruppe ist, Z ein Atom eines d-Block Uebergangselementes ausgewählt aus der Gruppe bestehend aus Titan, Vanadium, Chrom, Mangan, Eisen, Koblat, Nickel, Kupfer, Niob, Molybdän, Ruthenium, Rhodium, Palladium, Silber, Tantal, Wolfram, Rhenium, Osmium, Iridium, Platin oder Gold ist, und x eine positive ganze Zahl bedeutet, so dass Z eine geschlossene Elektronenkonfiguration aufweist;

(iii) aromatische Diazonium Ionen;

(iv) $[(R^{11})(R^{12}M)_a]^{+an}$,

worin a 1 oder 2 ist, n eine ganze Zahl von 1 bis 3 ist, M das Kation eines einwertigen bis dreiwertigen Metalls aus den Gruppen IVb bis VIIb, VIII oder Ib des Periodensystems ist, $R^{11}$ ein $\pi$-Aren ist und $R^{12}$ ein $\pi$-Aren oder das Anion eines $\pi$-Arens bedeutet;

(v) Sulfoniumionen;

(vi) Sulfoxoniumionen; und

(vii) Iodosylionen.

10. Verfahren nach einem der vorhergehenden Ansprüche, worin (C) ein o-Chinondiazid, ein Nitrophenylacetal oder ein Polyesterderivat oder endverkapptes Derivat eines Nitrophenylacetals, ein Harz mit einer Benzoingruppe in der Kette ein Sulfonatester eines aromatischen Alkohols enthaltend eine Carbonylgruppe in der α- oder β-Stellung zur Sulfonatestergruppe, ein aromatisches N-Sulfonyloxyimid oder ein aromatisches Oximsulfonat ist.

**11.** Verfahren nach einem der Ansprüche 1 bis 5, 7 und 10, worin die flüssige Zusammensetzung eine doppelfunktionelle Verbindung mit einer Acrylgruppe und einer o-Chinondiazidsulfonylestergruppe enthält.

**12.** Verfahren nach den Ansprüchen 10 oder 11, worin die flüssige Zusammensetzung auch ein in einer wässrigen Base lösliches filmbildendes Polymer enthält.

**13.** Verfahren nach einem der vorhergehenden Ansprüche, worin der in Stufe (iv) verwendete Entwickler eine wässrige Base ist.

**14.** Flüssiges Stoffgemisch geeignet für die Verwendung in einem Verfahren nach einem der Ansprüche 1 bis 7 und 10 bis 13 enthaltend
(A) einen unter Einwirkung von freien Radikalen polymerisierbaren Rest,
(B) einen strahlungsaktivierbaren Polymerisationsinitiator für (A), welcher ein Metallocen oder ein Gemisch einer organometallischen Verbindung eines Metalls der Gruppe IVa mit einem photoreduzierbaren Farbstoff ist, und
(C) einen strahlungssolubilisierbaren Rest, der durch Strahlung verschiedener Wellenlänge als der Initiator (B) aktiviert wird.

## Claims

**1.** A process for image formation, in which
(i) a substrate is coated with a liquid composition comprising
(A) a residue which is cationically polymerisable or polymerisable by the action of free radicals,
(B) a radiation-activatable polymerisation initiator for (A), and
(C) a radiation-solubilisable residue,
(ii) the composition is exposed to radiation having a wavelength at which (B) is activated but at which (C) is not substantially activated, and is optionally then heated, (A) polymerising and the liquid composition becoming solidified.
(iii) the solidified layer is exposed in a predetermined pattern to radiation having a wavelength which is different from that of the radiation used in stage (ii) and at which the residue (C) is activated, so that the solidified layer is rendered more soluble in a developer in the exposed areas of the surface than in the unexposed areas, and
(iv) the exposed areas of the layer are removed by the action of a developer.

**2.** A process according to claim 1, in which the liquid composition (B) comprises a radiation-activatable polymerisation initiator and either (1) a mixture of at least one compound having a polymerisable residue (A) and at least one compound having a radiation-solubilisable residue (C) which is activated by radiation of a wavelength which is different from that of (B), or (2) at least one dual-functional compound containing in the same molecule both a polymerisable residue (A) and a radiation-solubilisable residue (C) which is activated by radiation of a wavelength which is different from that of (B), or (3) at least the abovementioned dual-functional compound together with at least one compound having a polymerisable residue (A) and/or at least one compound having a radiation-solubilisable residue (C).

**3.** A process according to claims 1 or 2, in which (A) is an ethylenically unsaturated group or a mixture of an ethylenically unsaturated group and a thiol group.

**4.** A process according to claim 3, in which (A) is an ester containing a group of the formula I

$$CH_2{=}C(R^1)COO- \quad (I)$$

in which $R^1$ is a hydrogen, chlorine or bromine atom or an alkyl group of 1 to 4 carbon atoms.

**5.** A process according to claim 4, in which (A) is a monoacrylate or a monomethacrylate.

**6.** A process according to claim 3, in which (A) is a mixture of a phenol substituted by two or more allyl groups and a polythiol.

**7.** A process according to one of the preceding claims, in which the initiator (B) is a benzoin ether, an acyloin ether, a halogenated alkyl or aryl derivative, an aromatic carbonyl derivative, a metallocene, a mixture of a Group IVa organometallic compound with a photoreducible dye, a quinone, an aliphatic dicarbonyl compound, a 3-ketocoumarin, an acylphosphine oxide, a metal carbonyl or a mixture of a photoreducible dye with a reducing agent.

**8.** A process according to claims 1 or 2, in which (A) is a 1,2-epoxide, a vinyl ether or a mixture of these compounds.

**9.** A process according to claim 8, in which the initiator (B) is a compound of the formula VII

$$[R^{10}]^{+an} \qquad \frac{an}{q}\,[LT_m]^{-q} \qquad \text{(VII)}$$

in which L is a divalent to heptavalent metal or non metal, T is a halogen atom or else one of the radicals T may be a hydroxyl group, q is an integer from 1 to 3, m is an integer corresponding to the valency of L + q, a is 1 or 2, n is an integer from 1 to 3 and $R^{10}$ is an ion selected from the group consisting of

(i) aromatic iodonium ions;

(ii) $[G\text{-}Z\text{-}(CO)_x]^+$

wherein G is an arene or dienylium group, Z is an atom of a d-block transition element selected from the group consisting of titanium, vanadium, chromium, manganese, iron, cobalt, nickel, copper, niobium, molybdenum, ruthenium, rhodium, palladium, silver, tantalum, tungsten, rhenium, osmium, iridium, platinum and gold, and x is a positive integer such that Z has a closed electron configuration;

(iii) aromatic diazonium ions;

(iv) $[R^{11})\ (R^{12}M)_a]^{+an}$

wherein a is 1 or 2, n is an integer from 1 to 3, M is the cation of a monovalent to trivalent metal from groups IVb to VIIb, VIII or Ib of the Periodic Table; $R^{11}$ is a $\pi$-arene and $R^{12}$ is a $\pi$-arene or the anion of a $\pi$-arene;

(v) sulfonium ions;

(vi) sulfoxonium ions; and

(vii) iodosyl ions.

**10.** A process according to one of the preceding claims, in which (C) is an o-quinone diazide, a nitrophenyl acetal or a polyester derivative or end-capped derivative of a nitrophenyl acetal, a resin having a benzoin group in the chain, a sulfonate ester of an aromatic alcohol containing a carbonyl group in the position $\alpha$ or $\beta$ to the sulfonate ester group, an aromatic N-sulfonyloxyimide or an aromatic oxime sulfonate.

**11.** A process according to one of claims 1 to 5, 7 and 10, in which the liquid composition comprises a dual-functional compound having an acrylic group and an o-quinone-diazide-sulfonyl ester group.

**12.** A process according to claims 10 or 11, in which the liquid composition also contains a film-forming polymer soluble in an aqueous base.

**13.** A process according to one of the preceding claims, in which the developer used in stage (iv) is an aqueous base.

**14.** A liquid composition suitable for use in a process according to one of claims 1 to 7 and 10 to 13, comprising

(A) a residue which is polymerisable by the action of free radicals,

(B) a radiation-activatable polymerisation initiator for (A) which is a metallocene or a mixture of a Group IVa organometallic compound with a photoreducible dye, and

(C) a radiation-solubilisable residue which is activated by radiation of a wavelength which is different from that of the initiator (B).

## Revendications

**1.** Procédé de production d'images dans lequel :

(I) on enduit un substrat d'une composition liquide comprenant

(A) un radical pouvant donner lieu à une polymérisation par vue cationique ou sous l'action de radicaux libres,

(B) un inducteur de polymérisation activable par rayonnement pour (A) et

(C) un radical solubilisable par rayonnement,

(II) on irradie cette composition avec un rayonnement d'une longueur d'onde à laquelle (B) est activé mais (C) pour l'essentiel ne l'est pas, puis éventuellement on la chauffe, (A) se polymérisant alors et la composition liquide se solidifiant,

(III) on irradie la couche solidifiée en un modèle déterminé par un rayonnement d'une longueur d'onde différente de celle du rayonnement appliqué dans l'opération (II), ce qui active le radical (C), et ainsi la couche solidifiée devient plus soluble dans un révélateur dans les zones de la surface qui ont été irradiées que dans les zones non irradiées, et

(IV) on élimine ensuite les zones irradiées de la couche avec un révélateur.

2. Procédé selon la revendication 1, dans lequel la composition liquide comprend un inducteur de polymérisation photoactivable (B) avec soit (1) un mélange d'au moins un composé ayant un radical polymérisable (A) et d'au moins un composé avec un radical (C) solubilisable par rayonnement, qui est activé par un rayonnement de longueur d'onde différente que pour (B), soit (2) au moins un composé difonctionnel avec dans la même molécule à la fois un radical polymérisable (A) et un radical (C) solubilisable par rayonnement, qui est activé par un rayonnement de longueur d'onde différente que pour (B), soit encore (3) au moins un des composés difonctionnels mentionnés ci-dessus avec au moins un composé ayant un radical polymérisable (A) et/ou au moins un composé ayant un radical (C) solubilisable par rayonnement.

3. Procédé selon la revendication 1 ou 2 dans lequel (A) est un groupe insaturé éthylénique ou un mélange d'un groupe insaturé éthylénique et d'un groupe de thiol.

4. Procédé selon la revendication 3 dans lequel (A) est un ester avec un groupe de formule (I)

$$CH_2=C(R^1)COO- \qquad (I)$$

$R^1$ désignant un atome d'hydrogène, de chlore ou de brome ou un alkyle ayant de 1 à 4 atomes de carbone.

5. Procédé selon la revendication 4 dans lequel (A) est un monoacrylate ou un monométhacrylate.

6. Procédé selon la revendication 3 dans lequel (A) est un mélange d'un phénol substitué par deux ou plusieurs groupes alkyle et d'un polythiol.

7. Procédé selon l'une des revendications précédentes dans lequel l'inducteur (B) est un éther de benzoïne, un éther d'acyloïne, un dérivé alkylique ou arylique halogéné, un dérivé carbonylique aromatique, un métallocène, un mélange d'un composé organométallique d'un métal du groupe IVa et d'un colorant photoréductible, une quinone, un composé dicarbonylique aliphatique, une 3-cétocoumarine, un oxyde d'acylphosphine, un métal-carbonyle ou encore un mélange d'un colorant photoréductible et d'un agent réducteur.

8. Procédé selon la revendication 1 ou 2 dans lequel (A) est un 1,2-époxyde, un éther vinylique ou un mélange de ces deux composés.

9. Procédé selon la revendication 8 dans lequel l'inducteur (B) est un composé de formule VII

$$[R^{10}]^{+an} \frac{an}{q} [LT_m]^{-q} \qquad (VII)$$

dans laquelle L représente un métal ou un métaloïde divalent à heptavalent, T un atome d'halogène ou l'un des radicaux T pouvant être aussi un groupe hydroxylique, q est un entier de 1 à 3, m un nombre entier correspondant à la valence de L+q, a le nombre 1 ou 2 et n un entier de 1 à 3, et

$R^{10}$ un ion pris parmi les groupes suivants :

(I) ions d'iodonium aromatiques ;

(II) $[G-Z-(CO)_x]^+$

G représentant un arène ou un groupe diénylium, Z un atome d'un élément de transition du bloc d pris parmi le groupe constititué par le titane, le vanadium, le chrome, le manganèse, le fer, le cobalt, le nickel, le cuivre, le niobium, le molybdène, le ruthénium, le rhodium, le palladium, l'argent, le tantale,

le tungstène, le réhnium, l'osmium, l'iridium, le platine et l'or, et x un nombre entier positif, Z présentant alors une configuration électronique saturée,

(III) ions de diazonium aromatiques

(IV) $[(R^{11})(R^{12}M)_a]^{+an}$

M représentant le cation d'un métal monovalent à trivalent des groupes IVb à VIIb, VIII ou Ib de la classification périodique, $R^{11}$ un $\pi$-arène et $R^{12}$ un $\pi$-arène ou l'anion d'un $\pi$-arène,

(V) ions sufonium,

(VI) ions sulfoxonium, et

(VII) ions iodosyles.

**10.** Procédé selon l'une des revendications précédentes dans lequel (C) est un o-quinone-diazide, un nitrophénylacétal ou un dérivé de polyester ou bien un dérivé d'un nitrophénylacétal à terminaisons masquées, une résine ayant un groupe benzoïne sur sa chaine, un ester sulfonate d'un alcool aromatique avec un groupe carbonyle à la position $\alpha$ ou $\beta$ par rapport au groupe ester sulfonate, un N-sulfonyloxyimide aromatique ou un sulfonate d'oxime aromatique.

**11.** Procédé selon l'une des revendications 1 à 5, 7 et 10, dans lequel la composition liquide contient un composé difonctionnel avec un groupe acrylique et un groupe d'ester sulfonique de o-quinone-diazide.

**12.** Procédé selon la revendication 10 ou 11 dans lequel la composition liquide contient également un polymère filmogène soluble dans une base aqueuse.

**13.** Procédé selon l'une des revendications précédentes dans lequel le révélateur utilisé dans l'opération (IV) est une base aqueuse.

**14.** Mélange de matières liquide approprié à l'emploi dans un procédé selon l'une des revendications 1 à 7 et 10 à 13, mélange qui comprend :

(A) un radical pouvant donner lieu à une polymérisation sous l'action de radicaux libres,

(B) un inducteur de polymérisation pour (A), activable par un rayonnement, qui est un métallocène ou un mélange d'un composé organométallique d'un métal du groupe IVa et d'un colorant photoréductible, et

(C) un radical solubilisable par rayonnement, qui est activé par un rayonnement d'une longueur d'onde différente de celle du rayonnement pour l'inducteur (B).